# EUROPEAN PATENT APPLICATION

(11) **EP 4 797 922 A1**
(43) Date of publication of application: **26.08.2026**
(21) Application number: 26158526.9
(22) Date of filing: 13.02.2026
(51) Int. Cl.: H10K 59/35, H10K 59/131, H10K 59/121, H10K 59/88, H10K 59/123

(54) **DISPLAY DEVICE AND ELECTRONIC DEVICE**

(30) Priority: 19.02.2025 KR 20250021789
(71) Applicant: Samsung Display Co., Ltd., Yongin-si, Gyeonggi-do 17113 (KR)
(72) Inventor: CHA, Na Hyeon, 17113 Yongin-si (KR); SON, Sun Kwun, 17113 Yongin-si (KR); LEE, Cheol Gon, 17113 Yongin-si (KR); PARK, Jun Hyun, 17113 Yongin-si (KR)
(74) Representative: Walaski, Jan Filip

(57) **Abstract**

A display device includes a row that includes sub-pixels. The sub-pixels of the row include a first sub-pixel and a second sub-pixel each emitting light of a first color, and a third sub-pixel emitting light of a second color. A third anode electrode of the third sub-pixel is disposed between a first anode electrode of the first sub-pixel and a second anode electrode of the second sub-pixel. The first anode electrode of the first sub-pixel and the second anode electrode of the second sub-pixel are separated by the same distance from the third anode electrode of the third sub-pixel, and the first anode electrode of the first sub-pixel and the second anode electrode of the second sub-pixel have planar shapes substantially symmetrical with respect to the third anode electrode of the third sub-pixel.

## Description

### CROSS-REFERENCE TO RELATED APPLICATION(S)

This application claims priority to and benefits from Korean Patent Application No. 10-2025-0021789 filed on February 19, 2025 in the Korean Intellectual Property Office (KIPO).

### TECHNICAL FIELD

The disclosure relates to a display device and an electronic device.

### DISCUSSION OF THE RELATED ART

A display panel includes pixels, and each of the pixels includes a light-emitting element and a pixel circuit. The pixel circuit supplies a driving current to the light-emitting element corresponding to a data signal provided via a data line.

To reduce the number of data lines, some pixels in a row share a data line.

### SUMMARY

A display device includes a row including sub-pixels. The sub-pixels include a first sub-pixel and a second sub-pixel each emitting light of a first color, and a third sub-pixel emitting light of a second color. A third anode electrode of the third sub-pixel is disposed between a first anode electrode of the first sub-pixel and a second anode electrode of the second sub-pixel. The first anode electrode of the first sub-pixel and the second anode electrode of the second sub-pixel is separated by the same distance from the third anode electrode of the third sub-pixel. The first anode electrode of the first sub-pixel and the second anode electrode of the second sub-pixel have planar shapes substantially symmetrical to each other with respect to the third anode electrode of the third sub-pixel.

Each of the first anode electrode and the second anode electrode may include a portion extending from a corresponding emission region and electrically connected to a component via a contact hole, the component may be disposed under the contact hole.

The third anode electrode may have a larger size than the first anode electrode and the second anode electrode in plan view.

Each of the sub-pixels may include a light-emitting element and a pixel circuit supplying a driving current to the light-emitting element by using transistors. In the row, the pixel circuits of two first sub-pixels emitting light of the first color among the sub-pixels may be adjacent to each other in a first direction and be connected in common to a first data line. In the row, the pixel circuits of two third sub-pixels emitting light of the second color among the sub-pixels may be adjacent to each other in the first direction and be connected in common to a second data line.

The pixel circuit of each of sub-pixels may include the transistors. In the row, the transistors of two of the sub-pixels connected in common to a same data line among the sub-pixels are arranged symmetrically with respect to the same data line.

The first color may be green, and the second color may be blue.

The first anode electrode of the first sub-pixel may be disposed in the first direction from the pixel circuit of the first sub-pixel, and the second anode electrode of the second sub-pixel may be disposed in a direction opposite to the first direction from the pixel circuit of the second sub-pixel.

The first anode electrode of the first sub-pixel may be disposed at an edge of a display area on which an image is displayed, and the pixel circuit of the first sub-pixel may be disposed in a non-display area.

The display device may further include a dummy sub-pixel disposed at another edge of the display area and sharing a data line with a sub-pixel among the sub-pixels, the dummy sub-pixel may include a pixel circuit and may not comprise a light-emitting element, and the pixel circuit of the dummy sub-pixel may be disposed in the display area.

The row of sub-pixels may further include a fourth sub-pixel emitting light of the second color, and an anode electrode of the fourth sub-pixel may include an emission region, a first protrusion extending from the emission region and electrically connected to a component via a contact hole, the component may be disposed under the contact hole, and a second protrusion having a shape symmetrical to the first protrusion in the first direction, the second protrusion may not be physically connected to another configuration.

The sub-pixels of the row may further include a fifth sub-pixel and a sixth sub-pixel each emitting light of a third color, and a fifth anode electrode of the fifth sub-pixel and a sixth anode electrode of the sixth sub-pixel may be spaced apart from each other by the same distance from the third anode electrode of the third sub-pixel, and the fifth anode electrode of the fifth sub-pixel and a sixth anode electrode of the sixth sub-pixel may have different planar shapes.

Each of the fifth anode electrode and the sixth anode electrode may have a smaller size than the third anode electrode in plan view.

The sixth anode electrode may be disposed on a side of the third anode electrode and include a portion extending from a corresponding emission region and connected to a pixel circuit of the sixth sub-pixel via a contact hole disposed on another side of the third anode electrode, and the portion of the sixth anode electrode may extend while bypassing the third anode electrode.

The sixth sub-pixel may further include a connection line connecting the sixth anode electrode disposed at a side of the third anode electrode to a pixel circuit of the sixth sub-pixel disposed on another side of the third anode electrode, and the connection line may overlap the third anode electrode.

The first color may be red, and the second color may be blue.

The pixel circuit of the first sub-pixel may be disposed in the first direction from the first anode electrode of the first sub-pixel, and the pixel circuit of the second sub-pixel may be positioned in an opposite direction to the first direction from the second anode electrode of the second sub-pixel.

The display device may further include a dummy sub-pixel sharing a data line with a sub-pixel disposed at an edge of a display area among the sub-pixels, the dummy sub-pixel may include a pixel circuit and may not comprise a light-emitting element, the pixel circuits of the sub-pixels in the row may be disposed in the display area, and the pixel circuit of the dummy sub-pixel may be disposed in a non-display area.

An electronic device includes a processor providing input image data, a display device displaying an image based on the input image data, and a power supply supplying power to the display device. The display device includes a row comprising sub-pixels. The sub-pixels of the row includes a first sub-pixel and a second sub-pixel each emitting light of a first color, and a third sub-pixel emitting light of a second color. A third anode electrode of the third sub-pixel is disposed between a first anode electrode of the first sub-pixel and a second anode electrode of the second sub-pixel. The first anode electrode of the first sub-pixel and the second anode electrode of the second sub-pixel is separated by the same distance from the third anode electrode of the third sub-pixel. The first anode electrode of the first sub-pixel and the second anode electrode of the second sub-pixel has planar shapes substantially symmetrical to each other with respect to the third anode electrode of the third sub-pixel.

Each of the sub-pixels may include a light-emitting element and a pixel circuit supplying a driving current to the light-emitting element by using transistors, in the row, pixel circuits of two first sub-pixels emitting light of the first color among the sub-pixels may be adjacent to each other in a first direction and may be connected in common to a first data line, and in the row, pixel circuits of two third sub-pixels emitting light of the second color among the sub-pixels may be adjacent to each other in the first direction and may be connected in common to a second data line.

The electronic device may further include a window arranged on the display device, the window may include a light blocking area including an opaque material or a colored material, and a pixel circuit of the first sub-pixel may overlap the light blocking area of the window.

### BRIEF DESCRIPTION OF THE DRAWINGS

The above and other features of the disclosure will become more apparent by describing in further detail embodiments thereof with reference to the accompanying drawings, in which:
FIG. 1 is a schematic block diagram illustrating a display device according to embodiments;
FIG. 2 is a schematic diagram illustrating an embodiment of a sub-pixel included in a display device of FIG. 1;
FIG. 3 is a schematic drawing illustrating an embodiment of a display panel included in a display device of FIG. 1;
FIG. 4 is a schematic perspective view illustrating an embodiment of a display panel included in a display device of FIG. 1;
FIGS. 5 to 7 are layout views illustrating an embodiment of a display panel of FIG. 4;
FIGS. 8 and 9 are layout views illustrating an embodiment of a display panel of FIG. 4;
FIG. 10 is a schematic cross-sectional view taken along line I-I' of FIG. 9;
FIG. 11 is a schematic plan view illustrating an embodiment of a display panel included in a display device of FIG. 1;
FIG. 12 is a schematic cross-sectional view along lines II-II' and III-III' of FIG. 11;
FIG. 13 is a schematic perspective view illustrating a comparative example of a display panel of FIG. 4;
FIG. 14 is a layout view illustrating an embodiment of a display panel of FIG. 4;
FIG. 15 is a schematic cross-sectional view along line IV-IV' of FIG. 14;
FIG. 16 is a schematic perspective view illustrating an embodiment of a display panel included in a display device of FIG. 1;
FIGS. 17 and 18 are layout views illustrating an embodiment of a display panel of FIG. 16;
FIG. 19 is a schematic plan view illustrating an embodiment of a display panel included in a display device of FIG. 1;
FIG. 20 is a block diagram of an electronic device according to an embodiment; and
FIG. 21 shows schematic views of various embodiments of an electronic device.

### DETAILED DESCRIPTION

In the following description, for the purposes of explanation, numerous specific details are set forth in order to provide a thorough understanding of various embodiments or implementations of the disclosure. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the disclosure. Therefore, unless otherwise specified, the features, components, modules, layers, films, panels, regions, and/or aspects, etc., (hereinafter individually or collectively referred to as "elements"), of the various embodiments may be otherwise combined, separated, interchanged, and/or redisposed without departing from the disclosure.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals and/or reference characters denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may be different directions that are not perpendicular to one another.

For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc., may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements' relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, parts, and/or modules. Those skilled in the art will appreciate that these blocks, parts, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, parts, and/or modules being implemented by microprocessors or other similar hardware, they may be programmed and controlled using software (e.g., microcode) to perform various functions discussed herein and may optionally be driven by firmware and/or software. It is also contemplated that each block, part, and/or module may be implemented by dedicated hardware, or as a combination of dedicated hardware to perform some functions and a processor (e.g., one or more programmed microprocessors and associated circuitry) to perform other functions. Also, each block, part, and/or module of some embodiments may be physically separated into two or more interacting and discrete blocks, parts, and/or modules without departing from the scope of the disclosure. Further, the blocks, parts, and/or modules of some embodiments may be physically combined into more complex blocks, parts, and/or modules without departing from the scope of the disclosure.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly defined so herein.

Moreover, in the accompanying drawings, the thicknesses, ratios, and dimensions of the elements may not be to exact scale and may have been exaggerated for the benefit of effective explanation of the technical features associated with these elements. As such, the present disclosure shall not be restricted to the thicknesses, ratios, dimensions, etc. illustrated in the drawings.

Hereinafter, a display device according to embodiments of the present disclosure will be described with reference to the accompanying drawings.

Embodiments of the present disclosure relate to a display device and an electronic device designed to reduce power consumption by having two sub-pixels of the same color, as opposed to sub-pixels of different colors, being electrically connected to the same data line. The two sub-pixels of the same color may be independently driven by being connected to different gate lines.

In the display device and electronic device of the present disclosure, the anode electrodes and thus the emission regions of the two sub-pixels of the same color connected to the same data line are spaced apart from each other by a sub-pixel of another color. The anode electrodes of the sub-pixels of the same color that are connected to the same data line have left-right symmetry with respect to the anode electrode of the intervening sub-pixel of a different color, and also have left-right symmetry with respect to other anode electrodes of sub-pixels of the same color. As a result, the difference in parasitic capacitance of said anode electrodes of the sub-pixels having the same color and connected to the same data line is minimized, resulting in reduced or no luminance deviations, overcoming the need for compensation of data signals.

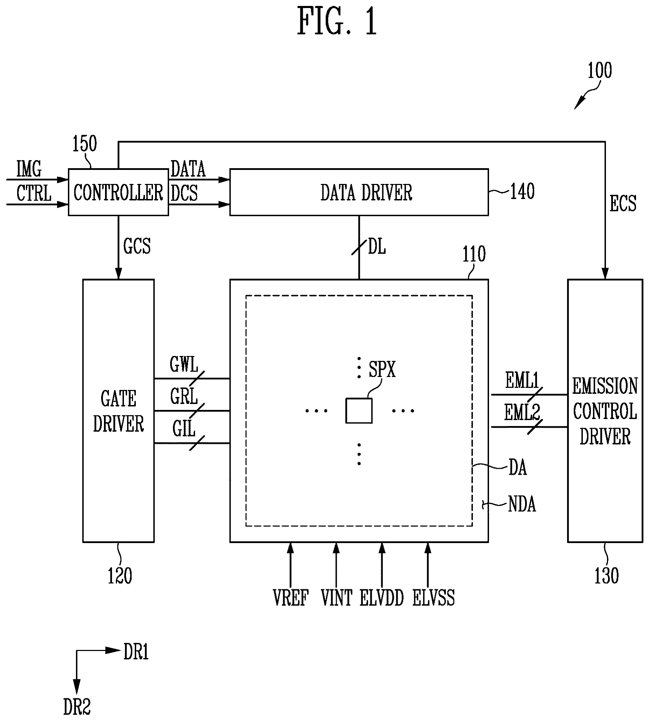

FIG. 1 is a schematic block diagram illustrating a display device 100 according to embodiments.

Referring to FIG. 1, the display device 100 may display an image. The display device 100 may include a display panel 110, a gate driver 120, an emission control driver 130, a data driver 140, and a controller 150.

The display panel 110 may include a display area DA and a non-display area NDA.

The display area DA may be an area where an image is displayed. For example, the display area DA may be defined as a central area of the display panel 110, but is not limited thereto. The display area DA may include sub-pixels SPX (or pixels). The arrangement of the sub-pixels SPX is not particularly limited and may be varied depending on the type of an electronic device to which the display device 100 is applied. The non-display area NDA may be defined as the remaining area of the display panel 110 excluding the display area DA. The non-display area NDA may include various lines, pads, etc.

The display panel 110 may be provided with a power voltage for driving the sub-pixels SPX. For example, the display panel 110 may be provided with a reference voltage VREF, an initialization voltage VINT, a first driving voltage ELVDD, and a second driving voltage ELVSS.

A first gate line GWL, a second gate line GRL, a third gate line GIL, a first emission control line EML1, and a second emission control line EML2 may extend in a first direction DR1.

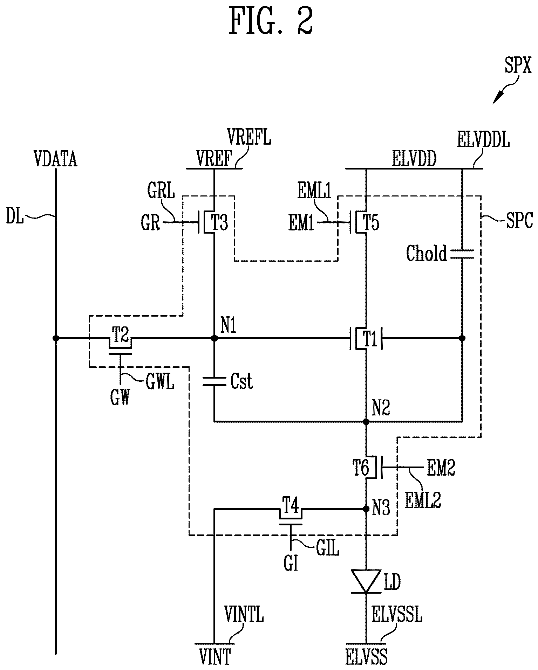

The gate driver 120 may be connected to the display panel 110 via the first gate line GWL, the second gate line GRL, and the third gate line GIL. The gate driver 120 may sequentially apply a first gate signal GW (see FIG. 2) to the first gate line GWL based on a gate control signal GCS in units of rows. The gate driver 120 may sequentially apply a second gate signal GR (see FIG. 2) to the second gate line GRL based on the gate control signal GCS in units of rows. The gate driver 120 may sequentially apply a third gate signal GI (see FIG. 2) to the third gate line GIL based on the gate control signal GCS in units of rows.

The emission control driver 130 may be connected to the display panel 110 via the first emission control line EML1 and the second emission control line EML2. The emission control driver 130 may apply a first emission control signal EM1 (see FIG. 2) to the first emission control line EML1 based on an emission control signal ECS. The emission control driver 130 may apply a second emission control signal EM2 (see FIG. 2) to the second emission control line EML2 based on the emission control signal ECS.

The data driver 140 may be connected to the display panel 110 via a data line DL. The data line DL may extend in a second direction DR2. The data driver 140 may apply a data signal VDATA (see FIG. 2) to the data line DL based on a data control signal DCS and image data DATA.

The controller 150 may control various operations of the display device 100. The controller 150 may receive input image data IMG and a control signal CTRL from an external device (e.g., a processor). The controller 150 may provide the gate control signal GCS to the gate driver 120 based on the control signal CTRL. The controller 150 may provide the emission control signal ECS to the emission control driver 130 based on the control signal CTRL. The controller 150 may provide the data control signal DCS to the data driver 140 based on the control signal CTRL. Further, the controller 150 may convert the input image data IMG to generate the image data DATA and provide the image data DATA to the data driver 140.

FIG. 2 is a schematic diagram illustrating an embodiment of a sub-pixel included in the display device of FIG. 1.

Referring to FIG. 2, the sub-pixel SPX may include a light-emitting element LD and a sub-pixel circuit SPC (or a pixel circuit) providing a driving current to the light-emitting element LD.

The sub-pixel circuit SPC may include a first transistor T1, a second transistor T2, a third transistor T3, a fourth transistor T4, a fifth transistor T5, a sixth transistor T6, a first capacitor Cst, and a second capacitor Chold. The first transistor T1, the second transistor T2, the third transistor T3, the fourth transistor T4, the fifth transistor T5, and the sixth transistor T6 may be N-type oxide semiconductor transistors, but embodiments are not necessarily limited thereto.

A first electrode of the first transistor T1 may be connected (or electrically connected) to a second node N2. A second electrode of the first transistor T1 may be connected to a first electrode of the fifth transistor T5. A gate electrode (or a first gate electrode) of the first transistor T1 may be connected to a first node N1. A lower electrode (or a second gate electrode) of the first transistor T1 may be connected to the second node N2. The first transistor T1 may be a double gate transistor. When the lower electrode of the first transistor T1 is connected to the second node N2, a gate-source voltage and a driving current of the first transistor T1 may be stabilized. The first transistor T1 may control the amount of the driving current supplied to the light-emitting element LD in response to a voltage of the first node N1.

A first electrode of the second transistor T2 may be connected to the first node N1. A second electrode of the second transistor T2 may be connected to the data line DL. A gate electrode of the second transistor T2 may be connected to the first gate line GWL. When the first gate signal GW is supplied to the first gate line GWL, the second transistor T2 may be turned on to electrically connect the data line DL and the first node N1. Accordingly, the data signal VDATA may be supplied to the first node N1.

A first electrode of the third transistor T3 may be connected to the first node N1. A second electrode of the third transistor T3 may be connected to a reference line VREFL. A gate electrode of the third transistor T3 may be connected to the second gate line GRL. When the second gate signal GR is supplied to the second gate line GRL, the third transistor T3 may be turned on to electrically connect the reference line VREFL and the first node N1. Accordingly, the reference voltage VREF of the reference line VREFL may be supplied to the first node N1.

A first electrode of the fourth transistor T4 may be connected to a third node N3. A second electrode of the fourth transistor T4 may be connected to an initialization line VINTL. A gate electrode of the fourth transistor T4 may be connected to the third gate line GIL. When the third gate signal GI is supplied to the third gate line GIL, the fourth transistor T4 may be turned on to electrically connect the initialization line VINTL and the third node N3. Accordingly, the initialization voltage VINT of the initialization line VINTL may be supplied to the third node N3.

A first electrode of the fifth transistor T5 may be connected to the second electrode of the first transistor T1. A second electrode of the fifth transistor T5 may be connected to a first driving line ELVDDL to which the first driving voltage ELVDD is supplied. A gate electrode of the fifth transistor T5 may be connected to the first emission control line EML1. The fifth transistor T5 may be turned off when the first emission control signal EM1 is supplied to the first emission control line EML1, and may be turned on in other cases. When the fifth transistor T5 is turned on, a current path may be formed in which a driving current may flow to the light-emitting element LD.

The first electrode of the sixth transistor T6 may be connected to the third node N3. The second electrode of the sixth transistor T6 may be connected to the second node N2. The gate electrode of the sixth transistor T6 may be connected to the second emission control line EML2. The sixth transistor T6 may be turned off when the second emission control signal EM2 is supplied to the second emission control line EML2, and may be turned on in other cases. When the sixth transistor T6 is turned on, a current path may be formed in which a driving current flows to the light-emitting element LD.

The first capacitor Cst may be connected between the first node N1 and the second node N2. The first capacitor Cst may store a voltage corresponding to the data signal VDATA.

The second capacitor Chold may be connected between the first driving line ELVDDL and the second node N2. The second capacitor Chold may stabilize a voltage of the second node N2.

The light-emitting element LD may be connected between the first driving line ELVDDL and a second driving line ELVSSL. For example, a first electrode (or an anode electrode) of the light-emitting element LD may be connected to the first driving line ELVDDL via the third node N3, the sixth transistor T6, the second node N2, the first transistor T1, and the fifth transistor T5. For example, a second electrode (or a cathode electrode) of the light-emitting element LD may be connected to the second driving line ELVSSL. The light-emitting element LD may generate light at a luminance corresponding to the amount of the driving current supplied from the sub-pixel circuit SPC.

The light-emitting element LD may be an organic light emitting diode, but embodiments are not necessarily limited thereto. For example, the light-emitting element LD may be an inorganic light emitting diode, such as a micro light emitting diode (LED), a quantum dot light emitting diode, or the like, or a device including a combination of organic and inorganic materials.

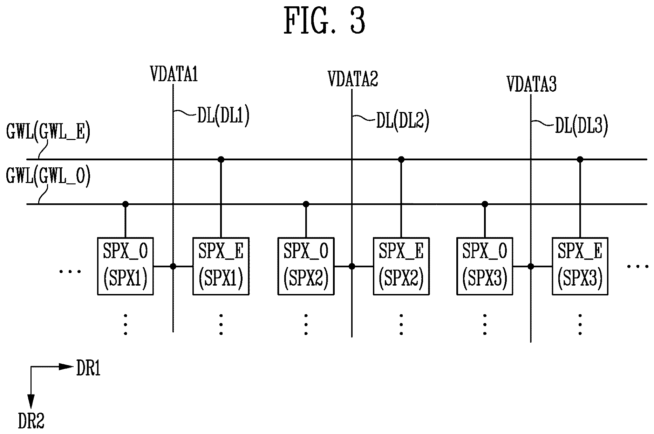

FIG. 3 is a schematic drawing illustrating an embodiment of the display panel 110 included in the display device 100 of FIG. 1. In FIG. 3, the connections of sub-pixels SPX_O and SPX_E, the first gate line GWL, and the data line DL are schematically shown in a single row.

Referring to FIG. 3, a pair of sub-pixels SPX_O and SPX_E may be connected in common to a corresponding data line DL. The pair of sub-pixels SPX_O and SPX_E may share the corresponding data line DL. For example, a pair of first sub-pixels SPX1 may be connected in common to a first data line DL1 from which a first data signal VDATA1 is supplied. The pair of first sub-pixels SPX1 may emit a first color of light (e.g., red light) in response to the first data signal VDATA1. For example, a pair of second sub-pixels SPX2 may be commonly connected to a second data line DL2 from which a second data signal VDATA2 is supplied. The pair of second sub-pixels SPX2 may emit a second color of light (e.g., blue light) in response to the second data signal VDATA2. For example, a pair of third sub-pixels SPX3 may be commonly connected to a third data line DL3 from which a third data signal VDATA3 is supplied. The pair of third sub-pixels SPX3 may emit light of a color corresponding to the third data signal VDATA3 (e.g., green light). The first data line DL1, the second data line DL2, and the third data line DL3 may extend in the second direction DR2 and may be spaced apart in the first direction DR1.

In order for the sub-pixels SPX_O and SPX_E of the same color to be commonly connected to a corresponding data line DL or to share the data line DL, the pair of sub-pixels SPX_O and SPX_E (or sub-pixel circuits thereof) may be sequentially arranged in the first direction DR1 by color. For example, two first sub-pixels SPX1, two second sub-pixels SPX2, and two third sub-pixels SPX3 may be sequentially arranged in the first direction DR1.

A sub-pixel SPX_E of the pair of sub-pixels SPX_O and SPX_E may be connected to a (1-1)th gate line GWL_E, and another sub-pixel SPX_O of the pair of sub-pixels SPX_O and SPX_E may be connected to a (1-2)th gate line GWL_O. The (1-1)th gate line GWL_E and the (1-2)th gate line GWL_O may extend in the first direction DR1 and may be spaced apart in the second direction DR2.

Accordingly, the data signal VDATA (see FIG. 2) may be supplied separately to the pair of sub-pixels SPX_O and SPX_E connected to the same data line DL. For example, when the first gate signal GW (see FIG. 2) is supplied to the (1-1)th gate line GWL_E, the first data signal VDATA1 may be supplied to the first sub-pixel SPX1 connected to the first data line DL1 and the (1-1)th gate line GWL_E, the second data signal VDATA2 may be supplied to the second sub-pixel SPX2 connected to the second data line DL2 and the (1-1)th gate line GWL_E, and the third data signal VDATA3 may be supplied to the third sub-pixel SPX3 connected to the third data line DL3 and the (1-1)th gate line GWL_E. For example, when the first gate signal GW is supplied to the (1-2)th gate line GWL_O, the first data signal VDATA1 may be supplied to the first sub-pixel SPX1 connected to the first data line DL1 and the (1-2)th gate line GWL_O, the second data signal VDATA2 may be supplied to the second sub-pixel SPX2 connected to the second data line DL2 and the (1-2)th gate line GWL_O, and the third data signal VDATA3 may be supplied to the third sub-pixel SPX3 connected to the third data line DL3 and the (1-2)th gate line GWL_O.

The pair of sub-pixels SPX_O and SPX_E (or sub-pixel circuits thereof) may be symmetrical to each other on the basis of the corresponding data line DL (or may have a symmetrical structure). For example, the pair of first sub-pixels SPX1 may be symmetrical with respect to a first data line DL1. For example, the pair of second sub-pixels SPX2 may be symmetrical with respect to a second data line DL2. For example, the pair of third sub-pixels SPX3 may be symmetrical with respect to ae third data line DL3.

As described above, in a row (e.g., single row) of sub-pixels, the pair of sub-pixels SPX_O and SPX_E (or sub-pixel circuits thereof) are sequentially arranged in the first direction DR1 by color, and the sub-pixels SPX_O and SPX_E of the same color may be connected to the corresponding data line DL in common or may share the data line DL. Since only data signal corresponding to the same color is provided to a data line DL, power consumption may be reduced compared to the case where sub-pixels of different colors share a data line DL i.e., where data signals corresponding to two colors are provided to a data line DL.

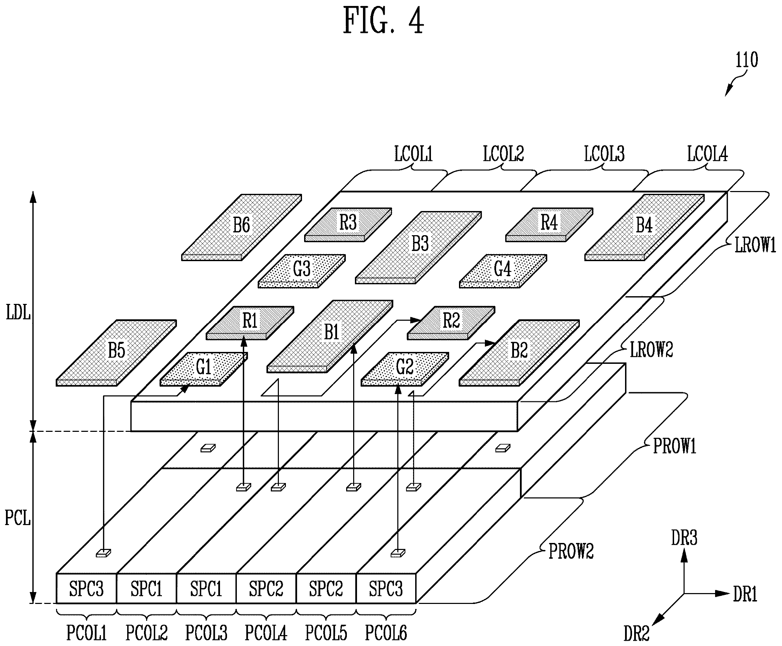

FIG. 4 is a schematic perspective view illustrating an embodiment of the display panel 110 included in the display device 100 of FIG. 1.

Referring to FIG. 4, the display panel 110 may include a pixel circuit layer PCL and a light-emitting element layer LDL.

The sub-pixel circuit SPC of the sub-pixel SPX of FIG. 2 may be arranged in the pixel circuit layer PCL, and the light-emitting element LD of the sub-pixel SPX of FIG. 2 may be arranged in the light-emitting element layer LDL.

The pixel circuit layer PCL may include a first sub-pixel circuit SPC1, a second sub-pixel circuit SPC2, and a third sub-pixel circuit SPC3. The first sub-pixel circuit SPC1 may be a sub-pixel circuit of the first sub-pixel SPX1 emitting light of the first color of FIG. 3, the second sub-pixel circuit SPC2 may be a sub-pixel circuit of the second sub-pixel SPX2 emitting light of the second color of FIG. 3, and the third sub-pixel circuit SPC3 may be a sub-pixel circuit of the third sub-pixel SPX3 emitting light of the third color of FIG. 3. As described with reference to FIG. 4, based on a single row, two first sub-pixel circuits SPC1, two second sub-pixel circuits SPC2, and two third sub-pixel circuits SPC3 may be arranged sequentially and repeatedly in the first direction DR1.

As shown in FIG. 4, in a second circuit row PROW2 (or a second row of the pixel circuit layer PCL), the third sub-pixel circuit SPC3, the two first sub-pixel circuits SPC1, the two second sub-pixel circuits SPC2, and the third sub-pixel circuit SPC3 may be arranged sequentially in the first direction DR1. The arrangement of the sub-pixel circuits SPC1 to SPC3 in a first circuit row PROW1 may be substantially the same as the arrangement of the sub-pixel circuits SPC1 to SPC3 in the second circuit row PROW2. In a first circuit column PCOL1 (or a first column of the pixel circuit layer PCL) and in a sixth circuit column PCOL6, the third sub-pixel circuit SPC3 may be arranged in the second direction DR2. In a second circuit column PCOL2 and a third circuit column PCOL3, the first sub-pixel circuit SPC1 may be arranged in the second direction DR2. In a fourth circuit column PCOL4 and a fifth circuit column PCOL5, the second sub-pixel circuit SPC2 may be arranged in the second direction DR2.

The light-emitting element layer LDL may include first anode electrodes R1 to R4, second anode electrodes B1 to B6, and third anode electrodes G1 to G4. The first anode electrodes R1 to R4 may be anode electrodes of the light-emitting elements LD of the first sub-pixel SPX1 emitting light of the first color of FIG. 3. The second anode electrodes B1 to B6 may be anode electrodes of the light-emitting elements LD of the second sub-pixel SPX2 emitting light of the second color of FIG. 3. The third anode electrodes G1 to G4 may be anode electrodes of the light-emitting elements LD of the third sub-pixel SPX3 emitting light of the third color of FIG. 3. The size (or the area) of the second anode electrodes B1 to B6 of the second sub-pixel SPX2 emitting light of the second color (e.g., blue) with low visual sensitivity may be greater than that of the first anode electrodes R1 to R4 or the third anode electrodes G1 to G4.

In a first element row LROW1 (or a first row of the light-emitting element layer LDL) and a second element row LROW2, the first anode electrodes R1 to R4 (or the third anode electrodes G1 to G4) and the second anode electrodes B1 to B6 may be arranged alternately in the first direction DR1. In a first element column LCOL1 (or a first column of the light-emitting element layer LDL), a third element column LCOL3, or the other odd numbered element column, the first anode electrodes R1 to R4 and the third anode electrodes G1 to G4 may be alternately arranged in the second direction DR2. In a second element column LCOL2, a fourth element column LCOL4, or the other even numbered element column, the second anode electrodes B1 to B6 may be arranged in the second direction DR2.

Anode electrodes of sub pixels of different colors may be placed between anode electrodes of sub-pixels of the same color. Sub-pixel circuits of a pair of sub-pixels of the same color may be arranged adjacent to each other, but anode electrodes of the pair of sub-pixels of the same color may not be arranged adjacent to each other. Accordingly, sub-pixel circuits and anode electrodes connected thereto (or light-emitting elements including the same) may misalign in a third direction DR3.

For example, the first anode electrode R1 and the third anode electrode G1 in the first element column LCOL1 may be disposed on the first sub-pixel circuit SPC1 of the second circuit column PCOL2 (or overlap in the third direction DR3). The second anode electrode B1 in the second element column LCOL2 may be disposed on the first sub-pixel circuit SPC1 of the third circuit column PCOL3 and the second sub-pixel circuit SPC2 of the fourth circuit column PCOL4. The first anode electrode R2 and the third anode electrode G2 in the third element row LCOL3 may be disposed on the second sub-pixel circuit SPC2 in the fifth circuit column PCOL5. The second anode electrode B2 in the fourth element column LCOL4 may be disposed on the third sub-pixel circuit SPC3 in the sixth circuit column PCOL6.

In an embodiment, relative to the second anode electrodes B1 to B6, the third anode electrodes G1 to G4 may have symmetrical connection structures with other third anode electrodes G1 to G4.

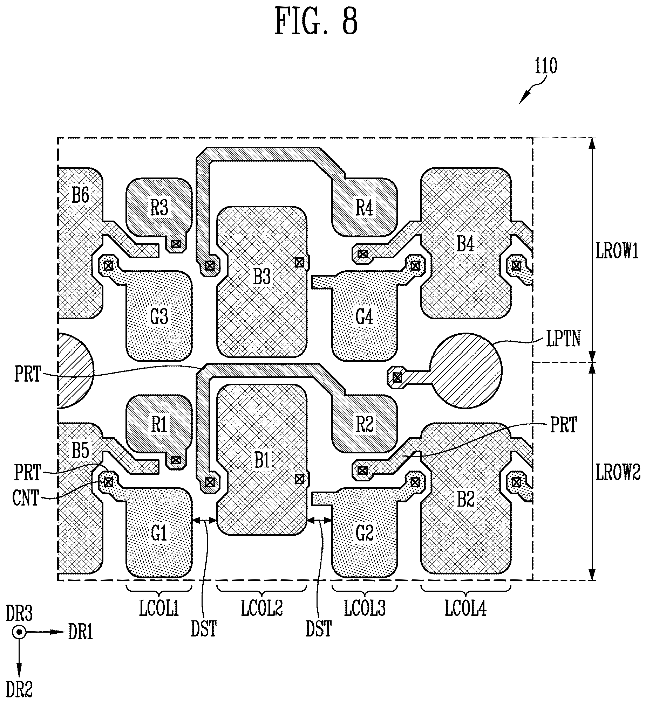

For example, based on the second anode electrode B1 of the second element column LCOL2, the third anode electrode G1 of the first element column LCOL1, and the third anode electrode G2 of the third element column LCOL3 are separated at the same distance. The structure in which the third anode electrode G1 of the first element column LCOL1 is connected to the third sub-pixel circuit SPC3 of the first circuit column PCOL1 may be symmetrical to the structure in which the third anode electrode G2 of the third element column LCOL3 is connected to the third sub-pixel circuit SPC3 of the sixth circuit column PCOL6. As will be described below with reference to FIG. 8, with respect to the second anode electrode B1 of the second element column LCOL2, the third anode electrode G1 of the first element column LCOL1 and the third anode electrode G2 of the third element column LCOL3 may have planar shapes which are symmetrical to each other. A parasitic capacitance of the third anode electrode G1 of the first element column LCOL1 (e.g., the parasitic capacitance between the second anode electrode B1 and the third anode electrode G1) and a parasitic capacitance of the third anode electrode G2 of the third element column LCOL3 may be the same, or the difference between the parasitic capacitances may be minimized. Therefore, the third sub-pixels SPX3 (see FIG. 3) including the third anode electrodes G1 to G4 and emitting light of the same color may emit light with the same luminance in response to the same data signal.

However, relative to the second anode electrodes B1 to B6, the first anode electrodes R1 to R4 may have different connection structures from other first anode electrodes R1 to R4.

For example, with reference to the second anode electrode B1 of the second element column LCOL2, the first anode electrode R1 of the first element column LCOL1 and the first anode electrode R2 of the third element column LCOL3 are spaced apart by the same distance. The structure in which the first anode electrode R1 of the first element column LCOL1 is connected to the first sub-pixel circuit SPC1 of the second circuit column PCOL2 may be different from the structure in which the first anode electrode R2 of the third element column LCOL3 is connected to the first sub-pixel circuit SPC1 of the third circuit column PCOL3. Luminance deviations may occur in some of the first sub-pixels SPX1 (see FIG. 3) which include the first anode electrodes R1 to R4 and emit light of the same color. Such luminance deviations may be compensated or eliminated by, for example, compensating for data signals for some of the first sub-pixels SPX1 in the data driver 140 of FIG. 1. Compared to the case where luminance deviations occur not only in the first sub-pixels SPX1 but also in the third sub-pixels SPX3, operations performed to compensate for the luminance deviations which occur in the embodiment of FIG. 4 may be simplified and the load may be reduced.

In embodiment of FIG. 4, the sub-pixel circuits SPC1 to SPC3 in the first to sixth circuit columns PCOL1 to PCOL6 and the anode electrodes in the first to fourth element columns LCOL1 to LCOL4 may constitute a unit structure, and may be repeatedly arranged in the first direction DR1 and the second direction DR2. Based on the unit structure, the overall configuration of the light-emitting element layer LDL may be shifted by a circuit column in the first direction DR1 from the overall configuration of the pixel circuit layer PCL.

As described above, since the arrangement of anode electrodes is different from that of sub-pixels, anode electrodes (or light-emitting elements including the same) may be misaligned with corresponding sub-pixel circuits. Relative to the second anode electrodes B1 to B6, the third anode electrodes G1 to G4 may have symmetrical connection structures or symmetrical planar shapes with other third anode electrodes G1 to G4. Accordingly, luminance deviations may not occur or may be minimized among the third sub-pixels SPX3 which include the third anode electrodes G1 to G4 and emit light of the same color. In other words, display quality may be improved.

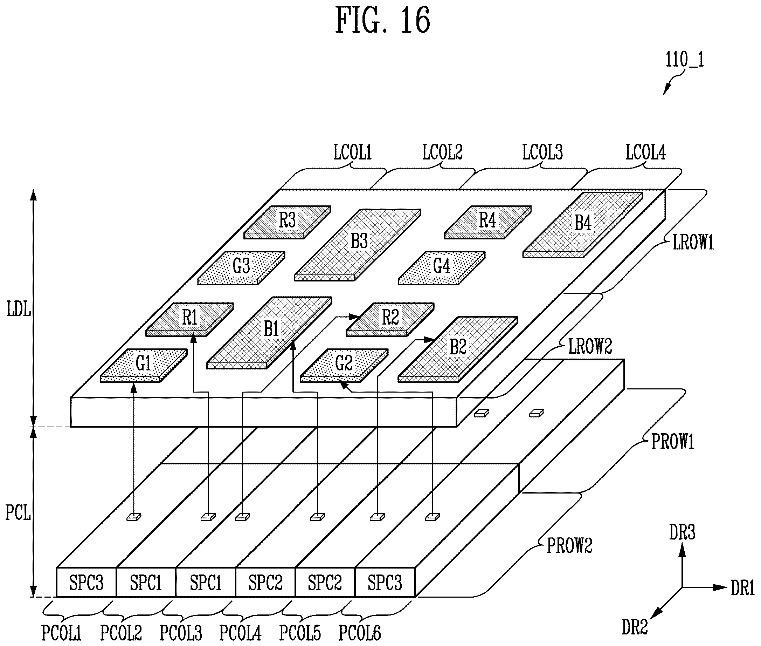

As described above with reference to FIG. 4, the first anode electrodes R1 to R4 having different connection structures from other first anode electrodes R1 to R4. However, the present disclosure is not limited thereto. For example, the first anode electrodes R1 to R4 may have the same connection structure as other first anode electrodes R1 to R4 (see FIG. 16).

Thus, symmetrical design of the third anode electrodes G1 to G4 may be achieved, while the first anode electrodes R1 to R4 are not fully symmetrical. Therefore the need for compensation of data signals delivered to the sub-pixel circuits connected to the third anode electrodes G1 to G4 is overcome, while data signals delivered to the sub-pixel circuits connected to the first anode electrodes R1 to R4 may still benefit from compensation. The embodiment of FIG. 16 discusses the converse where first anode electrodes R1 to R4 are symmetrical and thus not in need of compensation to data signals delivered to the sub-pixel circuits connected to the first anode electrodes R1 to R4while the third anode electrodes G1 to G4 are not fully symmetrical and therefore could benefit from data signal compensation.

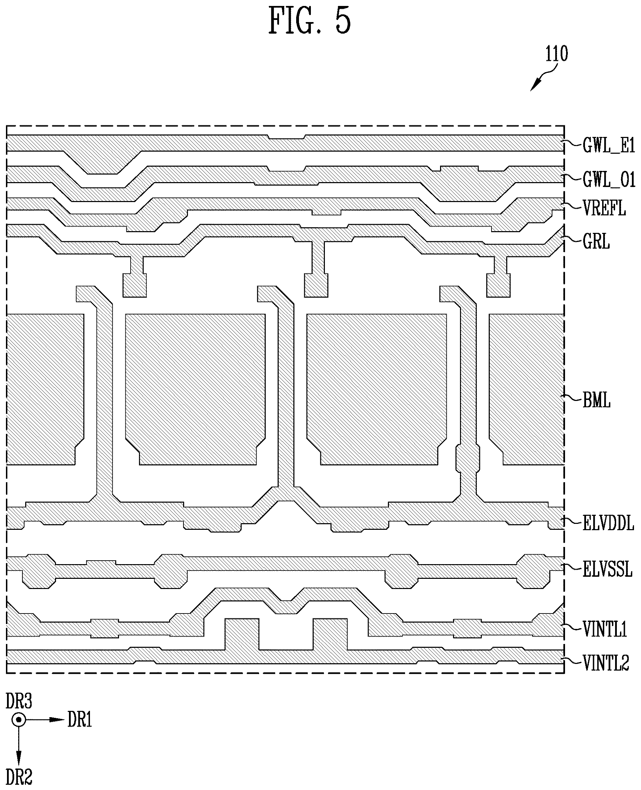

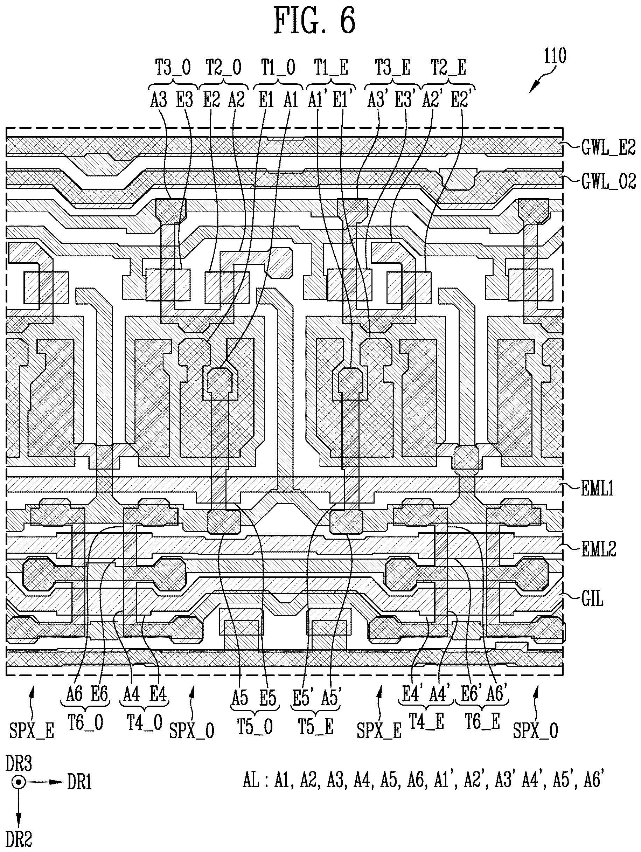

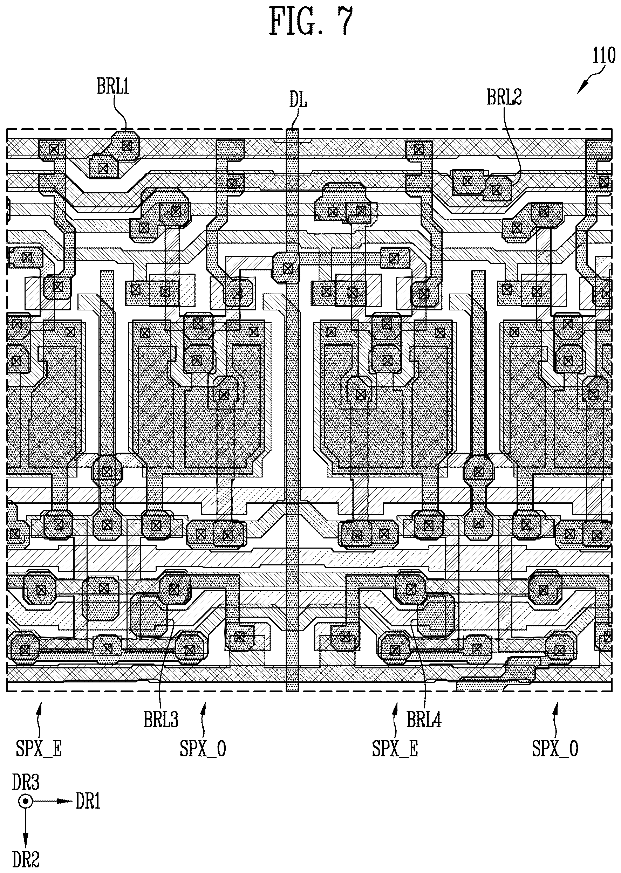

FIGS. 5 to 7 are layout views illustrating an embodiment of the display panel 110 of FIG. 4. FIG. 5 is a layout view of a first conductive layer of the pixel circuit layer PCL. FIG. 6 is a layout view of an active layer AL and a second conductive layer of the pixel circuit layer PCL. FIG. 7 is a layout view of a third conductive layer of the pixel circuit layer PCL.

Referring to FIG. 5, the first conductive layer may include a (1-1-1)th gate line GWL_E1, a (1-2-1)th gate line GWL_O1, the reference line VREFL, the second gate line GRL, a bottom metal layer BML, the first driving line ELVDDL, the second driving line ELVSSL, a first initialization line VINTL1, and a second initialization line VINTL2.

The (1-1-1)th gate line GWL_E1, the (1-2-1)th gate line GWL_O1, the reference line VREFL, and the second gate line GRL may extend generally in the first direction DR1. The (1-1-1)th gate line GWL_E1, the (1-2-1)th gate line GWL_O1, the reference line VREFL, and the second gate line GRL may be sequentially arranged in the second direction DR2.

The second gate line GRL may partially extend in the second direction DR2.

The bottom metal layers BML may be formed in the shape of islands having a size (e.g., predetermined or selectable size). The bottom metal layers BML may be spaced apart from each other in the first direction DR1.

The first driving line ELVDDL may extend generally in the first direction DR1. The first driving line ELVDDL may partially extend in the second direction DR2 and may be partially disposed between the bottom metal layers BML.

The second driving line ELVSSL may extend generally in the first direction DR1. The second driving line ELVSSL may be spaced apart from the first driving line ELVDDL in the second direction DR2.

The first initialization line VINTL1 may be the initialization line VINTL (see FIG. 2) which connects to the second sub-pixel SPX2 (see FIG. 3) and the third sub-pixel SPX3 (see FIG. 3). The first initialization line VINTL1 may extend generally in the first direction DR1. The first initialization line VINTL1 may be spaced apart from the second driving line ELVSSL in the second direction DR2.

The second initialization line VINTL2 may be the initialization line VINTL connected to the first sub-pixel SPX1 (see FIG. 3). The second initialization line VINTL2 may extend generally in the first direction DR1. The second initialization line VINTL2 may extend partially in the second direction DR2. The second initialization line VINTL2 may be spaced apart from the first initialization line VINTL1 in the second direction DR2.

Referring to FIG. 6, the active layer AL may be formed on the first conductive layer. The active layer AL may include a first active pattern A1, a second active pattern A2, a third active pattern A3, a fourth active pattern A4, a fifth active pattern A5, and a sixth active pattern A6 of the sub-pixel SPX_O connected to the (1-2)th gate line GWL_O (see FIG. 3). Further, the active layer AL may include a first active pattern A1', a second active pattern A2', a third active pattern A3', a fourth active pattern A4', a fifth active pattern A5', and a sixth active pattern A6' of the sub-pixel SPX_E connected to the (1-1)th gate line GWL_E (see FIG. 3). As shown in FIG. 6, at least some of the first active pattern A1', the second active pattern A2', the third active pattern A3', the fourth active pattern A4', the fifth active pattern A5', and the sixth active pattern A6' of the sub-pixel SPX_E may be arranged symmetrically in the first direction DR1 with the first active pattern A1, the second active pattern A2, the third active pattern A3, the fourth active pattern A4, the fifth active pattern A5, and the sixth active pattern A6 of the sub-pixel SPX_O, respectively. For example, the first active pattern A1', the fourth active pattern A4', the fifth active pattern A5', and the sixth active pattern A6' may be symmetrical to the first active pattern A1, the fourth active pattern A4, the fifth active pattern A5, and the sixth active pattern A6 in the first direction DR1, respectively.

The second conductive layer may be formed on the active layer AL. The second conductive layer may include a (1-1-2)th gate line GWL_E2, a (1-2-2)th gate line GWL_O2, the first emission control line EML1, the second emission control line EML2, and the third gate line GIL.

The (1-1-2)th gate line GWL_E2 and the (1-2-2)th gate line GWL_O2 may extend generally in the first direction DR1 . The (1-1-2)th gate line GWL_E2 may extend to overlap with the (1-1-1)th gate line GWL_E1 (see FIG. 5). The (1-2-2)th gate line GWL_O2 may extend to overlap with the (1-2-1)th gate line GWL_O1 (see FIG. 5).

The first emission control line EML1, the second emission control line EML2, and the third gate line GIL may extend generally in the first direction DR1 and be spaced apart in the second direction DR2.

First gate electrodes E1 and E1' may be formed on the first active patterns A1 and A1', respectively. The first gate electrodes E1 and E1' may overlap with channel regions of the first active patterns A1 and A1', respectively. The first gate electrode E1 and the first active pattern A1 may constitute a first transistor T1_O of the sub-pixel SPX_O. The first gate electrode E1' and the first active pattern A1' may constitute a first transistor T1_E of the sub-pixel SPX_E.

Second gate electrodes E2 and E2' may be formed on the second active patterns A2 and A2', respectively. The second gate electrodes E2 and E2' may overlap with channel regions of the second active patterns A2 and A2', respectively. The second gate electrode E2 and the second active pattern A2 may constitute a second transistor T2_O of the sub-pixel SPX_O. The second gate electrode E2' and the second active pattern A2' may constitute a second transistor T2_E of the sub-pixel SPX_E.

Third gate electrodes E3 and E3' may be formed on the third active patterns A3 and A3', respectively. The third gate electrodes E3 and E3' may overlap with channel regions of the third active patterns A3 and A3', respectively. The third gate electrode E3 and the third active pattern A3 may constitute a third transistor T3_O of the sub-pixel SPX_O. The third gate electrode E3' and the third active pattern A3' may constitute a third transistor T3_E of the sub-pixel SPX_E.

Fourth gate electrodes E4 and E4' may be formed on the fourth active patterns A4 and A4', respectively. The fourth gate electrodes E4 and E4' may overlap with channel regions of the fourth active patterns A4 and A4', respectively. The fourth gate electrode E4 and the fourth active pattern A4 may constitute a fourth transistor T4_O of the sub-pixel SPX_O. The fourth gate electrode E4' and the fourth active pattern A4' may constitute a fourth transistor T4_E of the sub-pixel SPX_E.

Fifth gate electrodes E5 and E5' may be formed on the fifth active patterns A5 and A5', respectively. The fifth gate electrodes E5 and E5' may overlap with channel regions of the fifth active patterns A5 and A5', respectively. The fifth gate electrode E5 and the fifth active pattern A5 may constitute a fifth transistor T5_O of the sub-pixel SPX_O. The fifth gate electrode E5' and the fifth active pattern A5' may constitute a fifth transistor T5_E of the sub-pixel SPX_E.

Sixth gate electrodes E6 and E6' may be formed on the sixth active patterns A6 and A6', respectively. The sixth gate electrodes E6 and E6' may overlap with channel regions of the sixth active patterns A6, A6', respectively. The sixth gate electrode E6 and the sixth active pattern A6 may constitute a sixth transistor T6_O of the sub-pixel SPX_O. The sixth gate electrode E6' and the sixth active pattern A6' may constitute a sixth transistor T6_E of the sub-pixel SPX_E.

As shown in FIG. 6, at least some of the transistors T1_O to T6_O of the sub-pixel SPX_O and the transistors T1_E to T6_E of the sub-pixel SPX_E may be arranged to be symmetrical in the first direction DR1 (or relative to the data line DL in FIG. 7). For example, the transistors T1_O, T4_O, T5_O, and T6_O may be symmetrical to the transistors T1_E, T4_E, T5_E, and T6_E, respectively.

Referring to FIG. 7, the third conductive layer may include the data lines DL, and bridge patterns (or bridge lines).

The data line DL may extend in the second direction DR2. The data line DL may partially extend in the first direction DR1. The pair of sub-pixels SPX_O and SPX_E may be connected to the data line DL.

A first bridge pattern BRL1 may connect the (1-1-1)th gate line GWL_E1 (see FIG. 5) and the (1-1-2)th gate line GWL_E2 (see FIG. 6). A second bridge pattern BRL2 may connect the (1-2-1)th gate line GWL_O1 (see FIG. 5) and the (1-2-2)th gate line GWL_O2 (see FIG. 6). When the (1-1)th gate line GWL_E (see FIG. 3) and the (1-2)th gate line GWL_O (see FIG. 3) are formed through double wirings, the resistance of the (1-1)th gate line GWL_E and the (1-2)th gate line GWL_O may be reduced, which may allow sufficient time to write the data signal VDATA (see FIG. 2).

A third bridge pattern BRL3 may be connected to the fourth transistor T4_O (see FIG. 6), and may constitute the third node N3 of the sub pixel SPX_O (see FIG. 2). A fourth bridge pattern BRL4 may be connected to the fourth transistor T4_E (see FIG. 6) and may constitute the third node N3 of the sub-pixel SPX_E.

The remaining bridge patterns may connect corresponding transistors among the transistors T1_O to T6_O and T1_E to T6_E. The arrangement of the remaining bridge patterns is as shown in FIG. 7, and the connection relationship of the transistors T1_O to T6_O and T1_E to T6_E according to the function of the remaining bridge patterns is as shown in FIG. 2. Therefore, a description of the arrangement and function of the remaining bridge patterns is omitted.

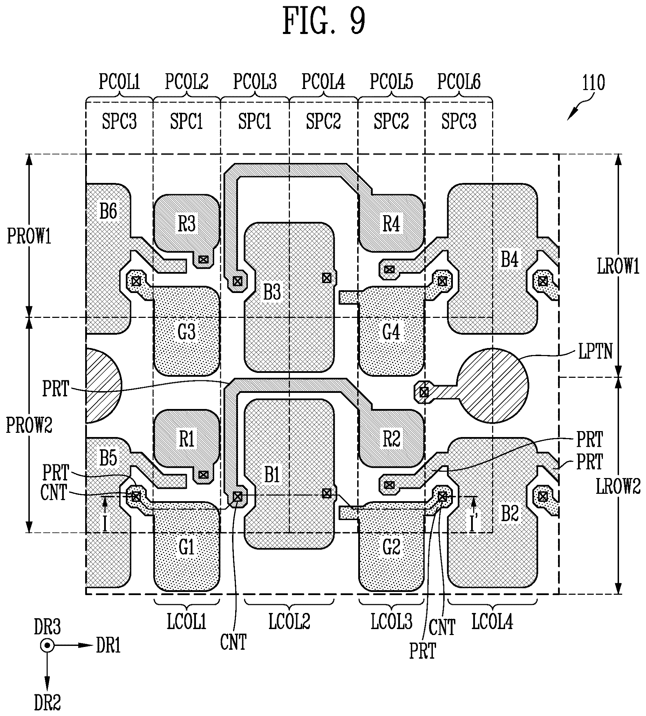

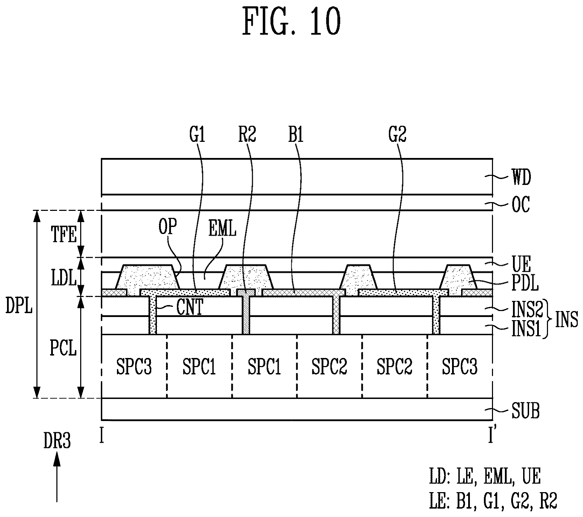

FIGS. 8 and 9 are layout views illustrating an embodiment of the display panel 110 of FIG. 4. In FIGS. 8 and 9, the anode electrodes of the light-emitting element layer LDL of FIG. 4 are shown, and in FIG. 9, the sub-pixel circuits are further shown schematically. FIG. 10 is a schematic cross-sectional view taken along line I-I' of FIG. 9.

Hereinafter, the cross-sectional structure of the display panel 110 is first described with reference to FIG. 10, followed by a description of the arrangement and shape of the anode electrodes with reference to FIGS. 8 and 9.

Referring first to FIG. 10, the display panel 110 may include a substrate SUB, a display element layer DPL, and a window WD.

The substrate SUB may include a transparent insulating material to allow light to pass through the substrate. The substrate SUB may be a rigid substrate or a flexible substrate.

The display element layer DPL may be arranged on the substrate SUB. The display element layer DPL may include the pixel circuit layer PCL, the light-emitting element layer LDL, and a thin-film encapsulation layer TFE. The pixel circuit layer PCL and the light-emitting element layer LDL may be arranged to overlap each other on the substrate SUB.

In the pixel circuit layer PCL, circuit elements of each of the sub-pixel circuits SPC1 to SPC3 may be arranged. As described above, a pair of first sub-pixel circuits SPC1, a pair of second sub-pixel circuits SPC2, and a pair of third sub-pixel circuits SPC3 may be arranged sequentially and repeatedly in the first direction DR1.

An insulating layer INS may be arranged in the pixel circuit layer PCL. The insulating layer INS may be an inorganic insulating film including an inorganic material (or substance) or an organic insulating film including an organic material. For example, the inorganic material may include at least one of silicon nitride SiNₓ), silicon oxide (SiOₓ), silicon oxynitride (SiOₓN_{y}), and aluminum oxide (AlOₓ). For example, the organic material may include at least one of polyacrylate resin, epoxy resin, phenolic resin, polyamide resin, polyimide resin, unsaturated polyester resin, polyphenylene ether resin, polyphenylene sulfide resin, and benzocyclobutene resin.

The insulating layer INS may be provided as a single layer, but may also be provided as multiple layers of at least two or more layers. For example, the insulating layer INS may include a first insulating layer INS1 and a second insulating layer INS2.

The light-emitting element layer LDL may be arranged on the insulating layer INS (or the pixel circuit layer PCL). The light-emitting element layer LDL may include the light-emitting element LD and a pixel defining layer PDL. The light-emitting element LD may include a lower electrode LE (or an anode electrode), an emissive layer EML, and an upper electrode UE. The lower electrode LE includes the anode electrodes B1, G1, G2, and R2, and the arrangement and shape of the lower electrode LE is described below with reference to FIGS. 8 and 9.

The lower electrode LE may be electrically connected to the corresponding sub-pixel circuit and receive a driving current. The lower electrode LE may include, but is not limited to, an opaque conductive material capable of reflecting light. In accordance with embodiments, the lower electrode LE may include a transparent conductive material.

The pixel defining layer PDL may be positioned on the lower electrode LE. The pixel defining layer PDL may include an opening OP which exposes the lower electrode LE. The pixel defining layer PDL may be a structure which defines (or divides) the emission region of each sub-pixel.

The pixel defining layer PDL may include an organic insulating layer including an organic material. The organic material (or an organic substance) may include, for example, acrylic resin, epoxy resin, phenolic resin, polyamide resin, polyimide resin, and the like. In some embodiments, the pixel defining layer PDL may include a light absorbing material or may be coated with a light absorber to absorb light from an external source. For example, the pixel defining layer PDL may include a carbon-based black pigment. However, the present disclosure is not limited thereto

The emissive layer EML may be arranged on the lower electrode LE exposed by the opening OP of the pixel defining layer PDL. The emissive layer EML may have a multilayer structure including a hole injection layer, a hole transport layer, an organic emissive layer, an electron transport layer, and an electron injection layer.

Depending on the sub-pixel, the emissive layer EML may include at least one of the emissive materials emitting different colors of light. For example, the emissive layer EML of the first sub-pixel SPX1 (see FIG. 3) may include at least one of the emissive materials emitting red light, the emissive layer EML of the second sub-pixel SPX2 (see FIG. 3) may include at least one of the emissive materials emitting blue light, and the emissive layer EML of the third sub-pixel SPX3 (see FIG. 3) may include at least one of the emissive materials emitting green light. However, the embodiments are not limited thereto. According to embodiments, each emissive layer EML may emit white light as a whole by stacking multiple emissive materials capable of generating different colors of light, such as red light, blue light, green light, etc. A color filter may be further arranged on the emissive layer EML. The color filter may include at least one of a red color filter, a blue color filter, and a green color filter.

The upper electrode UE may be arranged on the emissive layer EML and the pixel defining layer PDL. In embodiments, the upper electrode UE may be a cathode electrode. The upper electrode UE may be a common layer provided in common to the sub-pixels. The upper electrode UE may be provided in the form of a plate across the entire area of the display area DA (see FIG. 1). According to embodiments, the upper electrode UE may function as a half mirror which partially transmits and partially reflects light emitted from the emissive layer EML.

The upper electrode UE may be a thin metal layer having a thickness sufficient to transmit light emitted from the corresponding emissive layer EML. The upper electrode UE may include a metallic material or a transparent conductive material such that the upper electrode UE may have a small thickness. In embodiments, the upper electrode UE may include at least one of various transparent conductive materials, including indium tin oxide, indium zinc oxide, indium tin zinc oxide, aluminum zinc oxide, gallium zinc oxide, zinc tin oxide, and gallium tin oxide. In other embodiments, the upper electrode UE may include at least one of magnesium, silver, and mixtures thereof. However, the material of the upper electrode UE is not limited to the embodiment described above.

The thin-film encapsulation layer TFE may be arranged on the upper electrode UE. The thin-film encapsulation layer TFE may cover the light-emitting element layer LDL. The thin-film encapsulation layer TFE may prevent oxygen and/or moisture from penetrating into the light-emitting element layer LDL. In an embodiment, the thin-film encapsulation layer TFE may include a structure of alternating stacking of one or more inorganic films and one or more organic films.

An overcoat layer OC may be arranged on the thin-film encapsulation layer TFE. The overcoat layer OC may be a light transmissive material. The overcoat layer OC may flatten the top of the thin-film encapsulation layer TFE. The overcoat layer OC may include, but is not limited to, an acrylic epoxy material.

The window WD (or a cover window) may be arranged on top of the overcoat layer OC. The window WD may be a protective member arranged on the top of the overcoat layer OC to protect a configuration of the display device 100 (see FIG. 1). The window WD may be glass or plastic. When the window WD includes glass, ultra-thin glass (UTG) having a thickness of 0.1 mm or less may be used for flexible properties. However, the present disclosure is not limited thereto. The window WD may have a thickness of approximately 385 µm in the third direction DR3. However, the present disclosure is not limited thereto. According to embodiments, a polarizing member may be arranged between the window WD and the overcoat layer OC.

Referring to FIGS. 4, 8, and 9, the arrangement and shape of the anode electrodes in the first element row LROW1 is substantially the same or similar to the arrangement and shape of the anode electrodes in the second element row LROW2. Thus, the arrangement and shape of the anode electrodes in the second element row LROW2 will be described, and redundant descriptions will be omitted.

In the first element row LROW1 and the second element row LROW2, the first anode electrodes R1 to R4 (or the third anode electrodes G1 to G4) and the second anode electrodes B1 to B6 may be alternately arranged in the first direction DR1. In the first element column LCOL1 and the third element column LCOL3, the first anode electrodes R1 to R4 and the third anode electrodes G1 to G4 may be alternately arranged in the second direction DR2. In the second element column LCOL2 and the fourth element column LCOL4, the second anode electrodes B1 to B6 may be arranged in the second direction DR2.

In the second element column LCOL2, the second anode electrode B3 of the first element row LROW1 may be arranged adjacent to the second anode electrode B1 of the second element row LROW2 in the second direction DR2. In the fourth element column LCOL4, the second anode electrode B4 of the first element row LROW1 may be arranged spaced apart from the second anode electrode B2 of the second element row LROW2 in the second direction DR2. In the fourth element column LCOL4, a dummy pattern LPTN may be arranged between the second anode electrode B4 of the first element row LROW1 and the second anode electrode B2 of the second element row LROW2. The dummy pattern LPTN may connect a power line, such as the first driving line ELVDDL or the second driving line ELVSSL, to multiple layers (e.g., power lines arranged in an upper layer and a lower layer of the anode electrode layer), thereby reducing the resistance of the power line (and a resulting voltage drop). According to embodiments, the dummy pattern LTPN may be omitted.

Each of the anode electrodes R1 to R4, G1 to G4, and B1 to B6 may have a planar shape which is generally rectangular. For example, each of the anode electrodes R1 to R4, G1 to G4, and B1 to B6 may have a planar shape with rounded edges. However, the planar shape of each of the anode electrodes R1 to R4, G1 to G4, and B1 to B6 is not limited thereto. For example, each of the anode electrodes R1 to R4, G1 to G4, and B1 to B6 may have the other polygonal, circular, or other planar shape.

Each of the anode electrodes R1 to R4, G1 to G4, and B1 to B6 having the rectangular planar shapes may correspond to the opening OP of the pixel defining layer PDL (see FIG. 10). Since the opening OP of the pixel defining layer PDL corresponds to the emission region where light is emitted from the light-emitting element LD (see FIG. 10), each of the anode electrodes R1 to R4, G1 to G4, and B1 to B6 having the rectangular planar shapes may correspond to the emission region.

The size of the third anode electrodes G1 to G4 may be larger than that of the first anode electrodes R1 to R4, and that of the second anode electrodes B1 to B6 may be larger than that of the third anode electrodes G1 to G4.

As described above with reference to FIG. 4, the anode electrodes may be misaligned with the sub-pixel circuit connected thereto in the third direction DR3. As shown in FIG. 9, the first anode electrode R1 and the third anode electrode G1 in the first element column LCOL1 may overlap with the first sub-pixel circuit SPC1 in the second circuit column PCOL2 in the third direction DR3. The second anode electrode B1 in the second element column LCOL2 may overlap with the first sub-pixel circuit SPC1 of the third circuit column PCOL3 and the second sub-pixel circuit SPC2 of the fourth circuit column PCOL4 in the third direction DR3. The first anode electrode R2 and the third anode electrode G2 in the third element column LCOL3 may overlap with the second sub-pixel circuit SPC2 in the fifth circuit column PCOL5 in the third direction DR3. The second anode electrode B2 in the fourth element column LCOL4 may overlap with the third sub-pixel circuit SPC3 in the sixth circuit column PCOL6 in the third direction DR3.

In an embodiment, relative to the second anode electrodes B1 to B6, the third anode electrodes G1 to G4 may have planar shapes which are substantially symmetrical in the first direction DR1 with other third anode electrodes G1 to G4.

For example, relative to the second anode electrode B1 of the second element column LCOL2, the third anode electrode G1 of the first element column LCOL1 and the third anode electrode G2 of the third element column LCOL3 may be separated by the same distance DST. The third anode electrode G1 of the first element column LCOL1 and the third anode electrode G2 of the third element column LCOL3 may have planar shapes which are symmetrical with each other.

As described with reference to FIG. 4, the third anode electrode G1 of the first element column LCOL1 may be connected to the third sub-pixel circuit SPC3 of the first circuit column PCOL1, and may be positioned in the first direction DR1 from the third sub-pixel circuit SPC3 of the first circuit column PCOL1. As shown in FIG. 9, the third anode electrode G1 of the first element column LCOL1 may include a portion PRT extending or protruding in the opposite direction of the first direction DR1 from the emission region (i.e., a main portion) of the third anode electrode G1. The portion PRT may be connected to the third sub-pixel circuit SPC3 of the first circuit column PCOL1 (e.g., through the fourth bridge pattern BRL4 of FIG. 7) via a contact hole CNT.

The third anode electrode G2 of the third element column LCOL3 may be connected to the third sub-pixel circuit SPC3 of the sixth circuit column PCOL6, and may be disposed in the opposite direction of the first direction DR1 from the third sub-pixel circuit SPC3 of the sixth circuit column PCOL6. As shown in FIG. 9, the third anode electrode G2 of the third element column LCOL3 may include the portion PRT extending or protruding in the first direction DR1 from the emission region (i.e., the main portion) of the third anode electrode G2 to be connected to the third sub-pixel circuit SPC3 of the sixth circuit column PCOL6. The portion PRT may be connected to the third sub-pixel circuit SPC3 of the sixth circuit column PCOL6 (e.g., through the third bridge pattern BRL3 of FIG. 7) via the contact hole CNT.

The contact hole CNT connected to the portion PRT of the third anode electrode G1 of the first element column LCOL1 and the contact hole CNT connected to the portion PRT of the third anode electrode G2 of the third element column LCOL3 may be positioned to be symmetrical to each other on the basis of the second anode electrode B1 of the second element column LCOL2. Furthermore, the planar shape of the portion PRT of the third anode electrode G1 of the first element column LCOL1 and the planar shape of the portion PRT of the third anode electrode G2 of the third element column LCOL3 may be symmetrical to each other in the first direction DR1. Relative to the second anode electrode B1 of the second element column LCOL2, the third anode electrode G1 of the first element column LCOL1 and the third anode electrode G2 of the third element column LCOL3 may have a connection structure in which the third anode electrodes G1 and G2 are symmetrical to each other in the first direction DR1.

With respect to the second anode electrode B1 of the second element column LCOL2, a parasitic capacitance of the third anode electrode G1 of the first element column LCOL1 (e.g., a parasitic capacitance between the second anode electrode B1 and the third anode electrode G1) and a parasitic capacitance of the third anode electrode G2 of the third element column LCOL3 may be the same, or the difference between the parasitic capacitances may be minimized.

In an embodiment, the second anode electrodes B1 to B6 may each have shapes which are symmetrical with respect to the first direction DR1 (e.g., left-right symmetry). For example, the second anode electrode B2 of the fourth element column LCOL4 may include a first protrusion (or the portion PRT) extending/protruding in the opposite direction of the first direction DR1 from the emission region (i.e., the main portion) for connection with the second sub-pixel circuit SPC2 of the fifth circuit column PCOL5, and a second protrusion (or the portion PRT) having a shape symmetrical to the first protrusion. The second protrusion may extend/protrude in the first direction DR1 from the emission region (i.e., the main portion) of the second anode electrode B2, and may not be physically connected to any other configuration. When the second anode electrodes B1 to B6 each have a left-right symmetrical shape, the anode electrodes adjacent to the second anode electrodes B1 to B6 may have substantially the same parasitic capacitance with respect to the second anode electrodes B1 to B6.

Thus, the second anode electrodes B1 to B6 have a symmetrical design by having portions PRT protruding from opposite sides in the first direction DR1, however only one of these two portions PRT is operational by being connected to a sub-pixel circuit. By having one portion PRT of second anode electrodes B1 to B6 not electrically connected to anything, improved symmetry can be achieved, thereby reducing differences in parasitic capacitances between ones of the anode electrodes. This results in less luminance differences, which overcomes the need for extensive compensation to data signals.

Relative to the second anode electrodes B1 to B6, the first anode electrodes R1 to R4 may have different planar shapes from other first anode electrodes R1 to R4.

For example, relative to the second anode electrode B1 of the second element column LCOL2, the first anode electrode R1 of the first element column LCOL1 and the first anode electrode R2 of the third element column LCOL3 may be spaced apart by the same distance, but the planar shape of the first anode electrode R1 of the first element column LCOL1 may be different from the planar shape of the first anode electrode R2 of the third element column LCOL3.

As described above with reference to FIG. 4, the first anode electrode R1 of the first element column LCOL1 may be connected to the first sub-pixel circuit SPC1 of the second circuit column PCOL2, and may overlap with the first sub-pixel circuit SPC1 of the second circuit column PCOL2 in the third direction DR3. As shown in FIG. 9, the first anode electrode R1 of the first element column LCOL1 may include a portion extending or protruding in the second direction DR2 from the emission region (i.e., the main portion) of the first anode electrode R1 for connection with the first sub-pixel circuit SPC1 of the second circuit column PCOL2.

The first anode electrode R2 of the third element column LCOL3 may be connected to the first sub-pixel circuit SPC1 of the third circuit column PCOL3, and may be positioned in the first direction DR1 from the first sub-pixel circuit SPC1 of the third circuit column PCOL3. As shown in FIG. 9, for connection with the first sub-pixel circuit SPC1 of the third circuit column PCOL3, the first anode electrode R2 of the third element column LCOL3 may include a portion PRT extending in the opposite direction of the first direction DR1 from the emission region (i.e., the main portion) of the first anode electrode R2. The portion PRT of the first anode electrode R2 of the third element column LCOL3 may extend from a side of the second anode electrode B1 of the second element column LCOL2 to another side, bypassing the second anode electrode B1. Thus due to the portion PRT attached to first anode electrode R2 not being present in first anode electrode R1, the first anode electrodes R1 and R2 are not symmetrical and therefore may still benefit from data signal compensation.

As described above, relative to the second anode electrodes B1 to B6, the third anode electrodes G1 to G4 may have planar shapes which are symmetrical to other third anode electrodes G1 to G4. Thus, the third anode electrodes G1 to G4 may have the same or similar parasitic capacitance, and no or minimal luminance deviations may occur between the third sub-pixels SPX3 (see FIG. 3) which include the third anode electrodes G1 to G4 and emit light of the same color.

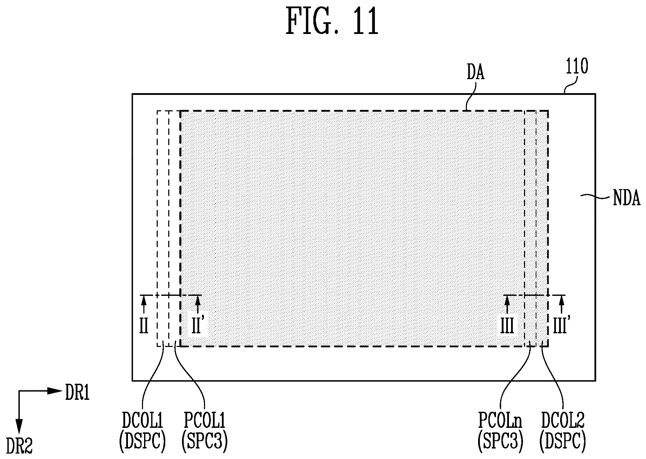

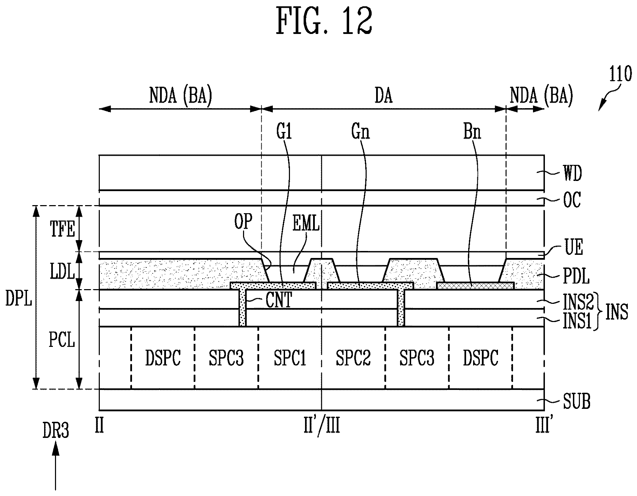

FIG. 11 is a schematic plan view illustrating an embodiment of the display panel 110 included in the display device 100 of FIG. 1. FIG. 12 is a schematic cross-sectional view taken along lines II - II' and III - III' of FIG. 11. The embodiments of FIGS. 4 to 10 may be applied to FIGS. 11 and 12.

Referring to FIGS. 1 and 11, a sub-pixel circuit of a sub-pixels disposed at an edge of the display area DA may be disposed in the non-display area NDA, not in the display area DA. For example, the first circuit column PCOL1 disposed at the outermost edge (e.g., at the leftmost side) in the opposite direction of the first direction DR1 may include the third sub-pixel circuit SPC3, and the third sub-pixel circuit SPC3 may be disposed in the non-display area NDA.

As described above, the embodiment of FIG. 4, i.e., the sub-pixel circuits SPC1 to SPC3 in the first to sixth circuit columns PCOL1 to PCOL6 and the anode electrodes in the first to fourth element columns LCOL1 to LCOL4 may form a unit structure, and based on the unit structure, the overall configuration of the light-emitting element layer LDL may be shifted by a circuit column in the first direction DR1 from the overall configuration of the pixel circuit layer PCL. No anode electrodes (and light-emitting elements) are arranged on the third sub-pixel circuit SPC3 which is disposed at the leftmost side. As shown in FIG. 12, the opening OP of the pixel defining layer PDL is not formed and the emissive layer EML is not arranged on the third sub-pixel circuit SPC3 disposed at the leftmost side.

In an embodiment, when the window WD includes a light blocking area BA, a sub-pixel circuit of a sub-pixel disposed at an edge of the display area DA may be disposed in the non-display area NDA, not in the display area DA. For example, the third sub-pixel circuit SPC3 of the first circuit column PCOL1 which is disposed at the outermost edge (e.g., at the leftmost side) in the opposite direction of the first direction DR1 may overlap with the light blocking area BA in the third direction DR3.

For example, the window WD overlapping with the display area DA may be optically transparent and have a visible light transmittance of about 90% or more. The light blocking area BA of the window WD may overlap with the non-display area NDA and may be a low light-transmissive area. In an embodiment, the light blocking area BA may include an opaque material which blocks light. The light blocking area BA may have a color (e.g., predetermined or selectable color). The light blocking area BA may be defined by a bezel layer provided separately from the transparent substrate defining the window WD, or may be defined by an ink layer inserted into or colored on the transparent substrate.

In an embodiment, the display panel 110 may further include a dummy sub-pixel (or a dummy pixel) which shares a data line with the sub-pixels disposed at the edge of the display area DA. The dummy sub-pixel may include a dummy sub-pixel circuit DSPC (or a dummy pixel circuit). The dummy sub-pixel circuit DSPC may be substantially the same as or similar to the sub-pixel circuit SPC of FIG. 2. The dummy sub-pixel does not include the light-emitting element LD (see FIG. 2). The dummy sub-pixel or the dummy sub-pixel circuit DSPC may be configured such that a sub-pixel disposed at the edge of the display area DA may have the same characteristics (e.g., parasitic capacitance) as another sub-pixel (e.g., a sub-pixel disposed between sub-pixels), and may be used to repair a sub-pixel with a failed sub-pixel circuit.

For example, a dummy pixel circuit DSPC of a first dummy circuit column DCOL1 may be disposed to the left of the third sub-pixel circuit SPC3 of the first circuit column PCOL1, and may share a data line with the third sub-pixel circuit SPC3. Referring to FIG. 3, for example, the third sub-pixel circuit SPC3 of the first circuit column PCOL1 may correspond to the sub-pixel SPX_E connected to the first data line DL1, and the dummy sub-pixel circuit DSPC of the first dummy circuit column DCOL1 may correspond to the sub-pixel SPX_O connected to the first data line DL1.

For example, the dummy sub-pixel circuit DSPC of a second dummy circuit column DCOL2 may be disposed to the right of the third sub-pixel circuit SPC3 of an nth circuit column PCOLn (or the last circuit column) and may share a data line with the third sub-pixel circuit SPC3. In the nth circuit column PCOLn, n may be a positive integer. Referring to FIG. 3, for example, the third sub-pixel circuit SPC3 of the nth circuit column PCOLn may correspond to the sub-pixel SPX_O connected to the third data line DL3, and the dummy sub-pixel circuit DSPC of the second dummy circuit column DCOL2 may correspond to the sub-pixel SPX_E connected to the third data line DL3.

In an embodiment, the dummy sub-pixel circuit DSPC disposed at an edge of the display area DA may be disposed in the non-display area NDA, while the dummy sub-pixel circuit DSPC disposed at another edge of the display area DA may be disposed in the display area DA, not in the non-display area NDA.

For example, the dummy sub-pixel circuit DSPC of the first dummy circuit column DCOL1 on the leftmost side may be disposed in the non-display area NDA. For example, the dummy sub pixel circuit DSPC of the second dummy circuit column DCOL2 on the rightmost side may be disposed in the display area DA. As shown in FIG. 12 (also referring to FIG. 4), a third anode electrode Gn connected to the third sub-pixel circuit SPC3 may be arranged on the second sub-pixel circuit SPC2, and a second anode electrode Bn connected to the second sub-pixel circuit SPC2 may be arranged on the third sub-pixel circuit SPC3. Since a width of the second anode electrode Bn is larger than a width of the third sub-pixel circuit SPC3, the second anode electrode Bn may also be arranged in an area to the right of the third sub-pixel circuit SPC3. In the empty space below the second anode electrode Bn (i.e., in the space where no sub-pixel circuit is arranged), the dummy sub-pixel circuit DSPC may be arranged.

As described above, the configuration of the light-emitting element layer LDL (e.g., anode electrodes or light-emitting elements) may be shifted by a circuit column in the first direction DR1 from the configuration of the pixel circuit layer PCL (e.g., sub-pixel circuits). Accordingly, the sub-pixel circuit of the sub-pixel and the dummy sub-pixel circuit DSPCat an edge of the display area DA may be disposed in the non-display area NDA, and the dummy sub-pixel circuit DSPC at another edge of the display area DA may be disposed in the display area DA.

In other words, the pairing of sub-pixels with corresponding data lines may also occur at the left and right edges of the display area DA by forming a dummy sub-pixel circuit DSPC in a non-display area NDA at one side of the display area DA, and forming an anode electrode over a dummy sub-pixel circuit DSPC at an opposite side of the display area DA. As a result, sub-pixels at the left and right extremities of the display area DA can still share a data line with another sub-pixel.

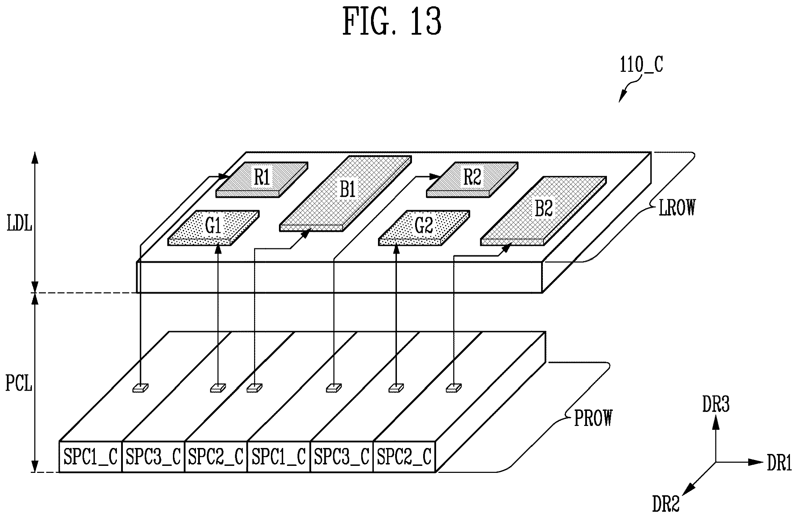

FIG. 13 is a schematic perspective view illustrating a comparative example of the display panel 110 of FIG. 4.

Referring to FIG. 13, a display panel 110_C may include the pixel circuit layer PCL and the light-emitting element layer LDL.

The sub-pixel circuit SPC of the sub-pixel SPX of FIG. 2 may be arranged in the pixel circuit layer PCL, and the light-emitting element LD of the sub-pixel SPX of FIG. 2 may be arranged in the light-emitting element layer LDL.

The pixel circuit layer PCL may include a first sub-pixel circuit SPC1_C, a second sub-pixel circuit SPC2_C, and a third sub-pixel circuit SPC3_C. In a row (e.g., single row or single circuit row PROW), the first sub-pixel circuit SPC1_C, the third sub-pixel circuit SPC3_C, and the second sub-pixel circuit SPC2_C may be arranged sequentially and repeatedly in the first direction DR1.

The light-emitting element layer LDL may include the first anode electrodes R1 and R2, the second anode electrodes B1 and B2, and the third anode electrodes G1 and G2. In a row (e.g., single row or an element row LROW), the first anode electrodes R1 and R2 (or the third anode electrodes G1 and G2) and the second anode electrodes B1 and B2 may be alternately arranged in the first direction DR1. The first anode electrodes R1 and R2 and the third anode electrodes G1 and G2 may be alternately arranged in the second direction DR2.

The first anode electrodes R1 and R2 and the third anode electrodes G1 and G2 may be disposed on the third sub-pixel circuit SPC3_C, and the second anode electrodes B1 and B2 may be disposed on the first sub-pixel circuit SPC1_C and the second sub-pixel circuit SPC2_C. The first anode electrodes R1 and R2 may be connected to the first sub-pixel circuit SPC1_C, the second anode electrodes B1 and B2 may be connected to the second sub-pixel circuit SPC2_C, and the third anode electrodes G1 and G2 may be connected to the third sub-pixel circuit SPC3_C.

As shown in FIG. 13, the connection structures of the third anode electrodes G1 and G2 may be the same as the connection structures of other third anode electrodes G1 and G2. For example, the connection structure between the third anode electrode G1 disposed on the left side of the second anode electrode B1 and the third sub-pixel circuit SPC3_C may be the same as the connection structure between the third anode electrode G2 disposed on the right side of the second anode electrode B1 and the third sub-pixel circuit SPC3_C. However, since the position of the second anode electrode B1 disposed in the second column is different from the position of the second anode electrode B2 disposed in the fourth column, there may be a difference in a parasitic capacitance of the third anode electrode G1 in the first column and a parasitic capacitance of the third anode electrode G2 in the third column. As a result, luminance deviations may occur in third sub-pixels SPX3 (see FIG. 3) which include the third anode electrodes G1 and G2 and emit light of the same color.

Similar to the third anode electrode G1 and G2, since the connection structure of the first anode electrode R1 of the first column is the same as the connection structure of the first anode electrode R2 of the third column, there is a difference in a parasitic capacitance of the first anode electrode R1 of the first column and a parasitic capacitance of the first anode electrode R2 of the third column, and luminance deviations may occur in first sub-pixels SPX1 (see FIG. 3) which include the first anode electrodes R1 and R2 and emit light of the same color.

Thus, in the embodiment of FIG. 4, relative to the second anode electrodes B1 to B6, the third anode electrodes G1 to G4 have symmetrical connection structures or symmetrical planar shapes with other third anode electrodes G1 to G4, so that no or minimal luminance deviations may occur between the third sub-pixels SPX3 (see FIG. 3) which include the third anode electrodes G1 to G4 and emit light of the same color.

Thus by having a pair of sub-pixels of the same color but in different columns share a single data line, and by forming the second anode electrodes B1 and B2 to be at the same position in the first direction DR1 in their respective columns, it may be possible to have one of the first anode electrodes R1 to R4 and the third anode electrodes G1 to G4 have a symmetrical configuration, resulting in similar parasitic capacitances and thus having similar luminance.

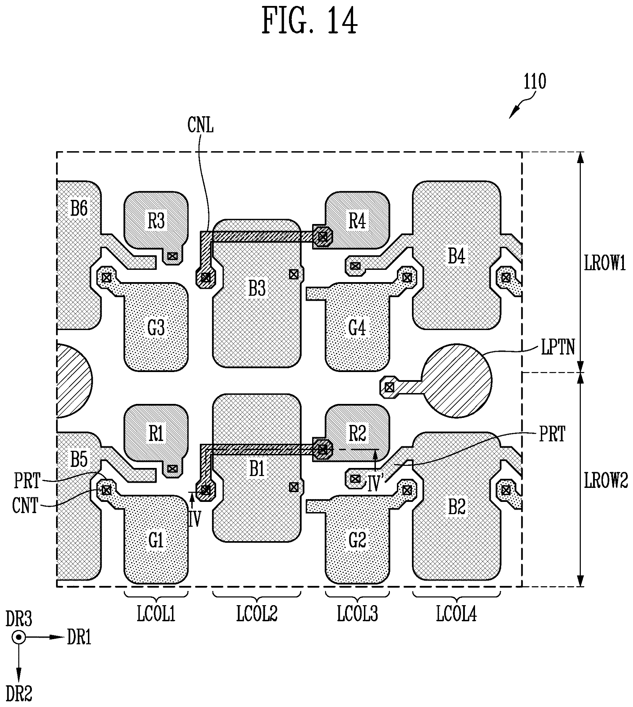

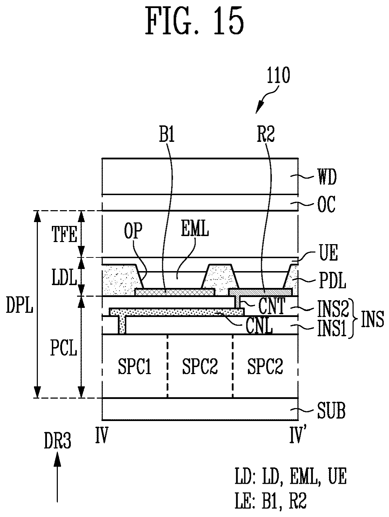

FIG. 14 is a layout view illustrating an embodiment of the display panel 110 of FIG. 4. FIG. 14 illustrates an anode electrode of the light-emitting element layer LDL of FIG. 4. FIG. 15 is a schematic cross-sectional view taken along line IV-IV' of FIG. 14.

Referring to FIGS. 8 to 10, FIG. 14, and FIG. 15, the embodiment of FIGS. 14 and 15 may be substantially the same as or similar to the embodiment of FIGS. 9 and 10, except for the shape and connection lines CNL (or connection patterns) of the first anode electrodes R2 and R4 of the third element column LCOL3. Accordingly, redundant descriptions are omitted.

The first anode electrode R2 of the third element column LCOL3 may be connected to the first sub-pixel circuit SPC1 which overlaps the second anode electrode B1 of the second element column LCOL2.

In an embodiment, the first anode electrode R2 of the third element column LCOL3 may be electrically connected to the first sub-pixel circuit SPC1 via the connection line CNL arranged on a different layer from the first anode electrode R2.

For example, as shown in FIG. 14, the connection line CNL may extend from the first anode electrode R2 (or a side of the second anode electrode B1) to another side of the second anode electrode B1 in the opposite direction of the first direction DR1. In plan view, the connection line CNL may extend across the second anode electrode B1.

For example, as shown in FIG. 15, the connection line CNL may be arranged between the first insulating layer INS1 and a second insulating layer INS2, and the connection line CNL may be connected to the first sub-pixel circuit SPC1. The first anode electrode R2 may be connected to the connection line CNL through the contact hole CNT on the side of the second anode electrode B1.

When the contact hole corresponding to the first anode electrode R2 of the third element column LCOL3 is positioned to be symmetrical with the contact hole corresponding to the first anode electrode R1 of the first element column LCOL1, and when the first anode electrode R2 of the third element column LCOL3 has a planar shape which is symmetrical to the planar shape of the first anode electrode R1 of the first element column LCOL1, parasitic capacitances of the first anode electrodes R1 and R2 may be similar to each other. In other words, the positions of the contact holes CNT corresponding to and the planar shapes of the first anode electrodes R1 and R2 may be determined such that the difference between the parasitic capacitances of the first anode electrodes R1 and R2 may be minimized.

Thus in the arrangement of FIGS. 14 and 15, the portion PRT connecting each of first anode electrodes R2 and R4 to the proper sub-pixel circuit SPC1 may instead be achieved by connection line CNL that may overlap the second anode electrodes B1 and B3 respectively. Therefore, it is not necessary to have to form portion PRT between ones of second anodes B1 and B3 as in the arrangement of FIG. 9.

FIG. 16 is a schematic perspective view illustrating an embodiment of the display panel 110 included in the display device 100 of FIG. 1.

Referring to FIGS. 4 and 16, the pixel circuit layer PCL of FIG. 16 may be substantially the same as or similar to the pixel circuit layer PCL of FIG. 4. Further, the light-emitting element layer LDL of FIG. 16 may be substantially the same as or similar to the light-emitting element layer LDL of FIG. 4. Accordingly, duplicative descriptions are omitted.

The first anode electrode R1 and the third anode electrode G1 in the first element column LCOL1 may be disposed on the third sub-pixel circuit SPC3 of the first circuit column PCOL1 (or overlapped with each other in the third direction DR3). The second anode electrode B1 in the second element column LCOL2 may be disposed on the first sub-pixel circuit SPC1 of the second circuit column PCOL2 and the first sub-pixel circuit SPC1 of the third circuit column PCOL3. The first anode electrode R2 and the third anode electrode G2 in the third element column LCOL3 may be disposed on the second sub-pixel circuit SPC2 in the fourth circuit column PCOL4. The second anode electrode B2 in the fourth element column LCOL4 may be disposed on the second sub-pixel circuit SPC2 in the fifth circuit column PCOL5 and the third sub-pixel circuit SPC3 in the sixth circuit column PCOL6.

In an embodiment, relative to the second anode electrodes B1 to B4, the first anode electrodes R1 to R4 may have symmetrical connection structures with other first anode electrodes R1 to R4.

For example, with reference to the second anode electrode B1 of the second element column LCOL2, the first anode electrode R1 of the first element column LCOL1 and the first anode electrode R2 of the third element column LCOL3 are separated by the same distance. The structure in which the first anode electrode R1 of the first element column LCOL1 is connected to the first sub-pixel circuit SPC1 of the second circuit column PCOL2 and the structure in which the first anode electrode R2 of the third element column LCOL3 is connected to the first sub-pixel circuit SPC1 of the third circuit column PCOL3 may be symmetrical to each other. On the basis of the second anode electrode B1 of the second element column LCOL2 having the largest size, a parasitic capacitance of the first anode electrode R1 of the first element column LCOL1 (e.g., the parasitic capacitance between the second anode electrode B1 and the first anode electrode R1) and a parasitic capacitance of the first anode electrode R2 of the third element column LCOL3 may be the same, or the difference between the parasitic capacitances may be minimized. Therefore, the first sub-pixels SPX1 (see FIG. 3) including the first anode electrodes R1 to R4 and emitting light of the same color may emit light with the same luminance in response to the same data signal.

Relative to the second anode electrodes B1 to B4, the third anode electrodes G1 to G4 may have different connection structures from other third anode electrodes G1 to G4.

For example, relative to the second anode electrode B1 of the second element column LCOL2, the third anode electrode G1 of the first element column LCOL1 and the third anode electrode G2 of the third element column LCOL3 are separated by the same distance. The structure in which the third anode electrode G1 of the first element column LCOL1 is connected to the third sub-pixel circuit SPC3 of the first circuit column PCOL1 may be different from the structure in which the third anode electrode G2 of the third element column LCOL3 is connected to the third sub-pixel circuit SPC3 of the sixth circuit column PCOL6.

The embodiment of FIG. 16, i.e., the sub-pixel circuits SPC1 to SPC3 in the first to sixth circuit columns PCOL1 to PCOL6 and the anode electrodes in the first to fourth element columns LCOL1 to LCOL4 may form a unit structure, and may be repeatedly arranged in the first direction DR1 and the second direction DR2. Based on the unit structure, the overall configuration of the light-emitting element layer LDL may be aligned in the third direction DR3 with the overall configuration of the pixel circuit layer PCL.

As described above, with respect to the second anode electrodes B1 to B4, the first anode electrodes R1 to R4 may have a symmetrical connection structure or symmetrical planar shapes with other first anode electrodes R1 to R4. Accordingly, luminance deviations may not occur or may be minimized among the first sub-pixels SPX1 (see FIG. 3) which include the first anode electrodes R1 to R4 and emit light of the same color.

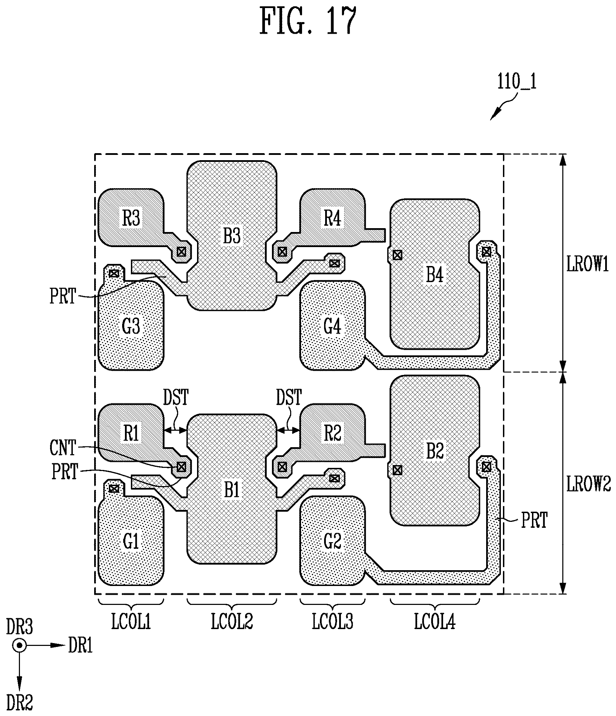

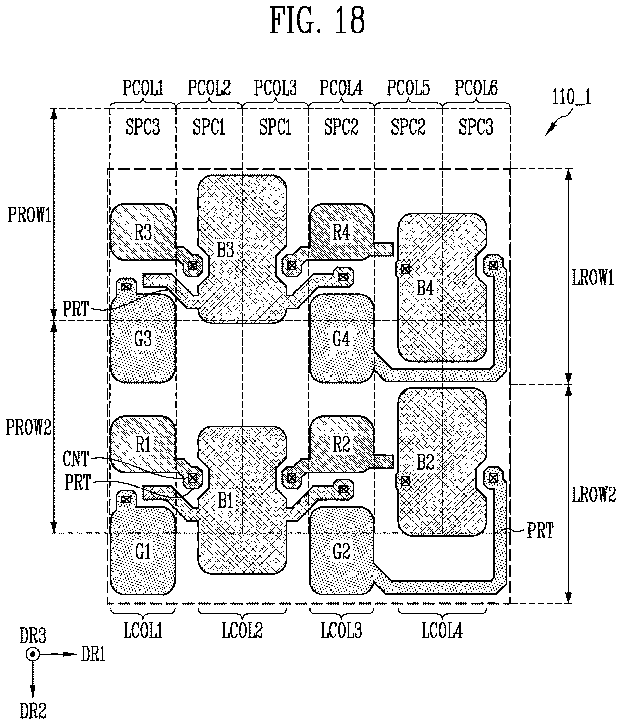

FIGS. 17 and 18 are layout views illustrating an embodiment of the display panel 110 of FIG. 16. In FIGS. 17 and 18, the anode electrodes (or the lower electrodes LE (see. FIG. 10)) of the light-emitting element layer LDL of FIG. 16 are shown, and in FIG. 18, the sub-pixel circuits are further shown schematically.

Referring to FIGS. 16 to 18, except for the shape of the anode electrodes, the arrangement of the anode electrodes according to the embodiment of FIGS. 16 to 18 is substantially the same as or similar to the arrangement of the anode electrodes according to the embodiment of FIGS. 4 and 8. Thus, redundant descriptions are omitted.

Each of the anode electrodes R1 to R4, G1 to G4, and B1 to B4 may have a planar shape which is generally rectangular. For example, but not limited to, each of the anode electrodes R1 to R4, G1 to G4, and B1 to B6 may have a planar shape with rounded edges.

As described above, each of the anode electrodes R1 to R4, G1 to G4, and B1 to B4 having rectangular planar shapes may correspond to an emission region.

As described with reference to FIG. 16, the first anode electrode R1 and the third anode electrode G1 in the first element column LCOL1 may overlap in the third direction DR3 with the third sub-pixel circuit SPC3 of the first circuit column PCOL1. The second anode electrode B1 in the second element column LCOL2 may overlap in the third direction DR3 with the first sub-pixel circuit SPC1 of the second circuit column PCOL2 and the first sub-pixel circuit SPC1 of the third circuit column PCOL3. The first anode electrode R2 and the third anode electrode G2 in the third element column LCOL3 may overlap in the third direction DR3 with the second sub-pixel circuit SPC2 of the fourth circuit column PCOL4. The second anode electrode B2 in the fourth element column LCOL4 may overlap in the third direction DR3 with the second sub-pixel circuit SPC2 of the fifth circuit column PCOL5 and the third sub-pixel circuit SPC3 of the sixth circuit column PCOL6.

In an embodiment, relative to the second anode electrodes B1 to B4, the first anode electrodes R1 to R4 may have planar shapes which are substantially symmetrical to other first anode electrodes R1 to R4 in the first direction DR1.

For example, with respect to the second anode electrode B1 of the second element column LCOL2, the first anode electrode R1 of the first element column LCOL1 and the first anode electrode R2 of the third element column LCOL3 may be separated by the same distance DST. The first anode electrode R1 of the first element column LCOL1 and the first anode electrode R2 of the third element column LCOL3 may have planar shapes which are symmetrical to each other.

As described with reference to FIG. 16, the first anode electrode R1 of the first element column LCOL1 may be connected to the first sub-pixel circuit SPC1 of the second circuit column PCOL2, and may be disposed in the opposite direction of the first direction DR1 from the first sub-pixel circuit SPC1 of the second circuit column PCOL2. As shown in FIG. 18, the first anode electrode R1 of the first element column LCOL1 may include the portion PRT extending or protruding in the first direction DR1 from the emission region (i.e., the main portion) of the first anode electrode R1. The portion PRT may be connected to the first sub-pixel circuit SPC1 (e.g., through the third bridge pattern BRL3 of FIG. 7) via the contact hole CNT.

The first anode electrode R2 of the third element column LCOL3 may be connected to the first sub-pixel circuit SPC1 of the third circuit column PCOL3, and may be positioned in the first direction DR1 from the first sub-pixel circuit SPC1 of the third circuit column PCOL3. As shown in FIG. 18, the first anode electrode R2 of the third element column LCOL3 may include the portion PRT extending or protruding in the opposite direction of the first direction DR1 from the emission region (i.e., the main portion) of the first anode electrode R2 to be connected to the first sub-pixel circuit SPC1 of the third circuit column PCOL3. The portion PRT may be connected to the first sub-pixel circuit SPC1 (e.g., through the fourth bridge pattern BRL4) of FIG. 7 via the contact hole CNT.

The planar shape of the portion PRT of the first anode electrode R1 of the first element column LCOL1 and the planar shape of the portion PRT of the first anode electrode R2 of the third element column LCOL3 may be symmetrical to each other in the first direction DR1. Relative to the second anode electrode B1 of the second element column LCOL2, the first anode electrode R1 of the first element column LCOL1, and the first anode electrode R2 of the third element column LCOL3 may have connection structures in which the first anode electrodes R1 and R2 are symmetrical to each other in the first direction DR1.

Relative to the second anode electrode B1 of the second element column LCOL2, a parasitic capacitance of the first anode electrode R1 of the first element column LCOL1 and a parasitic capacitance of the first anode electrode R2 of the third element column LCOL3 may be the same, or the differences between the parasitic capacitances may be minimized.

In an embodiment, the second anode electrodes B1 to B4 may each have shapes which are symmetrical with respect to the first direction DR1 (e.g., left-to-right symmetry). For example, the second anode electrode B1 of the second element column LCOL2 may include a first protrusion extending/protruding in the first direction DR1 from the emission region (i.e., the main portion) for connection with the second sub-pixel circuit SPC2 of the fourth circuit column PCOL4, and a second protrusion having a shape symmetrical to the first protrusion. The second protrusion may extend/protrude in the opposite direction of the first direction DR1 from the emission region (i.e., the main portion) of the second anode electrode B1 and may not be physically connected to another configuration. When the second anode electrodes B1 to B4 each have left-right symmetry, the anode electrodes adjacent to the second anode electrodes B1 to B4 may have substantially the same parasitic capacitance with respect to the second anode electrodes B1 to B4.

Relative to the second anode electrodes B1 to B4, the third anode electrodes G1 to G4 may have different planar shapes from other third anode electrodes G1 to G4.

For example, relative to the second anode electrode B1 of the second element column LCOL2, the third anode electrode G1 of the first element column LCOL1 and the third anode electrode G2 of the third element column LCOL3 may be spaced apart from each other by the same distance, but the planar shape of the third anode electrode G1 of the first element column LCOL1 may be different from the planar shape of the third anode electrode G2 of the third element column LCOL3.

As described above with reference to FIG. 16, the third anode electrode G1 of the first element column LCOL1 may be connected to the third sub-pixel circuit SPC3 of the first circuit column PCOL1, and may overlap with the third sub-pixel circuit SPC3 of the first circuit column PCOL1 in the third direction DR3. As shown in FIG. 18, for connection with the third sub-pixel circuit SPC3 of the first circuit column PCOL1, the third anode electrode G1 of the first element column LCOL1 may include a portion extending or protruding in the opposite direction of the second direction DR2 from the emission region (i.e., the main portion) of the third anode electrode G1.

The third anode electrode G2 of the third element column LCOL3 may be connected to the third sub-pixel circuit SPC3 of the sixth circuit column PCOL6. As shown in FIG. 18, for connection with the third sub-pixel circuit SPC3 of the sixth circuit column PCOL6, the third anode electrode G2 of the third element column LCOL3 may include a portion PRT extending in the first direction DR1 from the emission region (i.e., the main portion) of the third anode electrode G2. The portion PRT of the third anode electrode G2 of the third element column LCOL3 may extend from a side of the second anode electrode B2 of the fourth element column LCOL4 to another side, bypassing the second anode electrode B2. However, the third anode electrode G2 is not limited thereto. For example, similar to the embodiment of FIGS. 14 and 15, the third anode electrode G2 of the third element column LCOL3 may also be electrically connected to the third sub-pixel circuit SPC3 of the sixth circuit column PCOL6 via the connection line CNL (see FIGS. 14 and 15) arranged on a different layer from the third anode electrode G2.

As described above, relative to the second anode electrodes B1 to B4, the first anode electrodes R1 to R4 may have planar shapes which are symmetrical to other first anode electrodes R1 to R4. Thus, the first anode electrodes R1 to R4 may have the same or similar parasitic capacitance, and no or minimal luminance deviations may occur between the first sub-pixels SPX1 (see FIG. 3) which include the first anode electrodes R1 to R4 and emit light of the same color.

Thus, the arrangement of FIGS. 16 to 18 is the converse of that of FIGS. 4 to 9 in that the first anode electrodes R1 to R4 each have left-right symmetry while the third anode electrodes G1 to G4 may not be symmetrical, primarily due to portion PRT of third anode electrode G2 not being present in third anode electrode G1. Therefore compensation of data signals may instead be avoided for first anode electrodes R1 to R4 corresponding to red sub-pixels.

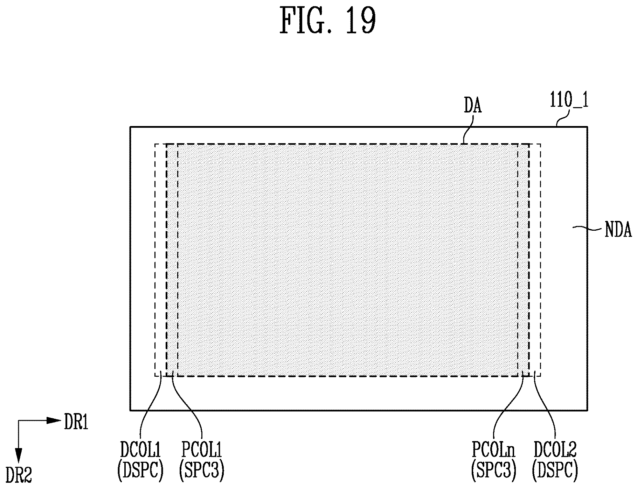

FIG. 19 is a schematic plan view illustrating an embodiment of the display panel 110 included in the display device 100 of FIG. 1. In FIG. 19, the embodiment of FIGS. 16 to 18 may be applied.

Referring to FIGS. 1 and 19, a display panel 110_1 may further include a dummy sub-pixel (or a dummy pixel) which shares a data line with the sub-pixels disposed at the edge of the display area DA. The dummy sub-pixel may include the dummy sub-pixel circuit DSPC (or a dummy pixel circuit). The dummy sub-pixel circuit DSPC may be substantially the same as or similar to the sub-pixel circuit SPC of FIG. 2. The dummy sub-pixel does not include the light-emitting element LD (see FIG. 2). The dummy sub-pixel or the dummy sub-pixel circuit DSPC may be configured such that a sub-pixel disposed at the edge of the display area DA may have the same characteristics (e.g., a parasitic capacitance) as other sub-pixels (e.g., sub-pixels disposed between sub-pixels), and may be used to repair a sub-pixel with a failed sub-pixel circuit.

For example, the dummy pixel circuit DSPC of the first dummy circuit column DCOL1 may be disposed to the left of the third sub-pixel circuit SPC3 of the first circuit column PCOL1, and may share a data line with the third sub-pixel circuit SPC3. Referring to FIG. 3, for example, the third sub-pixel circuit SPC3 of the first circuit column PCOL1 may correspond to the sub-pixel SPX_E connected to the first data line DL1, and the dummy sub-pixel circuit DSPC of the first dummy circuit column DCOL1 may correspond to the sub-pixel SPX_O connected to the first data line DL1.

For example, the dummy sub-pixel circuit DSPC of the second dummy circuit column DCOL2 may be disposed to the right of the third sub-pixel circuit SPC3 of the nth circuit column PCOLn (or the last circuit column) and may share a data line with the third sub-pixel circuit SPC3. In the nth circuit column PCOLn, n may be a positive integer. Referring to FIG. 3, for example, the third sub-pixel circuit SPC3 of the nth circuit column PCOLn may correspond to the sub-pixel SPX_O connected to the third data line DL3, and the dummy sub-pixel circuit DSPC of the second dummy circuit column DCOL2 may correspond to the sub-pixel SPX_E connected to the third data line DL3.

In an embodiment, sub-pixel circuits disposed at both edges of the display area DA are disposed in the display area DA, and the dummy sub-pixel circuit DSPC sharing a data line with the sub-pixel circuits may be disposed in the non-display area NDA. For example, the third sub-pixel circuit SPC3 of the first circuit column PCOL1 on the leftmost side may be disposed in the display area DA, and the dummy sub-pixel circuit DSPC of the first dummy circuit row DCOL1 may be disposed in the non-display area NDA. For example, the third sub-pixel circuit SPC3 of the nth circuit column PCOLn on the rightmost side may be disposed in the display area DA, and the dummy sub-pixel circuit DSPC of the second dummy circuit row DCOL2 may be disposed in the non-display area NDA.

Compared to the embodiment of FIGS. 11 and 12, in the embodiment of FIG. 19, the sub-pixel circuits of the sub-pixels at the edges of the display area DA may be disposed in the display area DA, and the dummy sub-pixel circuit DSPC which shares a data line with the sub-pixel circuits may be disposed in the non-display area DNA.

Compared with FIGS. 11 and 12, FIG. 19 derived from the embodiment of FIGS. 16 to 18 has the dummy sub-pixel circuit DSPC disposed at the right side of the display area DA being disposed in the non-display area NDA, while the third sub-pixel circuit SPC3 disposed at the left side of the display area DA is disposed in the display area DA. This is the converse of that of FIGS. 11 and 12.

A display device according to an embodiment may be applied to various electronic devices. An electronic device according to an embodiment includes the above-described display device, and may further include modules or devices having other additional functions other than the display device.

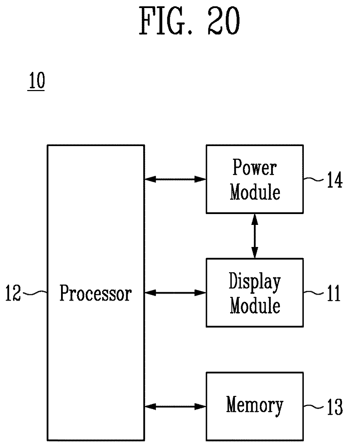

FIG. 20 is a block diagram of an electronic device 10 according to an embodiment. Referring to FIG. 20, the electronic device 10 according to an embodiment may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), and a controller.

The memory 13 may store data and/or information used to operate the processor 12 or the display module 11. When the processor 12 executes an application stored in the memory 13, image data signals (e.g., input image data IMG shown in FIG. 1) and/or input control signals (e.g., the control signal CTRL shown in FIG. 1) may be transferred to the display module 11. The display module 11 may process the received signals and output image information on a display screen.

The power module 14 may include a power supply module, such as a power adapter or a battery device, and a power conversion module. The power conversion module converts power supplied by the power supply module and generates power to operate the electronic device 10.

At least one of the above-described components of the electronic device 10 may be included in the display device according to the above-described embodiments. Some of the modules may be included in the display device and others may be provided separately from the display device. For example, the display module 11 is included in the display device, whereas the processor 12, the memory 13, and the power module 14 are not included in the display device and are instead provided separately from the display device in the electronic device 10.

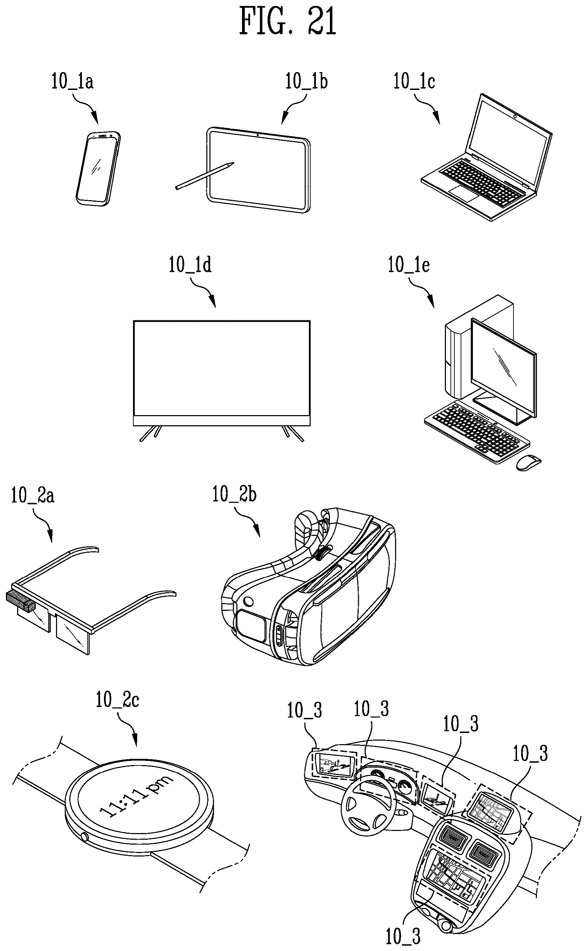

FIG. 21 shows schematic views of various embodiments of an electronic device.

Referring to FIG. 21, various types of electronic devices to which embodiments of the display device are applied may include an electronic device to display images such as a smartphone 10_1a, a tablet 10_1b, a laptop computer 10_1c, a television (TV) 10_1d, and a desktop monitor 10_1e, a wearable electronic device including a display module such as smart glasses 10_2a, a head-mounted display (HMD) 10_2b, and a smart watch 10_2c, and an automotive electronic device 10_3 including a display module such as a center information display (CID) disposed at the instrument cluster, the center fascia, and the dashboard of a vehicle, and a room mirror display.

In a display device and an electronic device according to embodiments of the present disclosure, a pair of sub-pixels emitting light of the same color in a row (e.g., single row) may share a data line. Thus, fluctuations in a data signal on the data line may be reduced, and power consumption may be reduced.

Furthermore, based on an anode electrode with the largest size, a pair of anode electrodes (which are included in sub-pixels emitting light of the same color and disposed at the same distance) may have symmetrical connection structures (connected to the sub-pixel circuits) or may have planar shapes which are symmetrical to each other. Accordingly, luminance deviations between the pair of sub-pixels may be avoided or minimized, and display quality may be improved.

It will be apparent to those skilled in the art that various modifications can be made to the above-described embodiments of the disclosure without departing from the scope of the invention as defined by the claims.

## Claims

1. A display device, comprising:
a row (LROW2) comprising sub-pixels, wherein
the sub-pixels of the row comprise:
a first sub-pixel and a second sub-pixel each emitting light of a first color; and
a third sub-pixel emitting light of a second color,
a third anode electrode (B1) of the third sub-pixel is disposed between a first anode electrode (G1) of the first sub-pixel and a second anode electrode (G2) of the second sub-pixel,
the first anode electrode (G1) of the first sub-pixel and the second anode electrode (G2) of the second sub-pixel are separated by the same distance (DST) from the third anode electrode (B1) of the third sub-pixel, and
the first anode electrode of the first sub-pixel and the second anode electrode of the second sub-pixel have planar shapes that are substantially symmetrical with respect to the third anode electrode of the third sub-pixel.

2. The display device of claim 1, wherein
each of the first anode electrode and the second anode electrode comprises a portion extending from a corresponding emission region and electrically connected to a component via a contact hole, the component being disposed under the contact hole, and
the third anode electrode is larger than the first anode electrode and the second anode electrode in plan view.

3. The display device of claim 1, wherein
each of the sub-pixels comprises a light-emitting element and a pixel circuit supplying a driving current to the light-emitting element, in the row, the pixel circuits of two first sub-pixels emitting light of the first color among the sub-pixels are adjacent to each other in a first direction and are connected in common to a first data line,
in the row, the pixel circuits of two third sub-pixels emitting light of the second color among the sub-pixels are adjacent to each other in the first direction and are connected in common to a second data line,
the pixel circuit of each of the sub-pixels comprises transistors, and
in the row, transistors of two of the sub-pixels connected in common to a data line among the sub-pixels are arranged symmetrically with respect to the data line.

4. The display device of claim 3, wherein the first color is green, and the second color is blue.

5. The display device of claim 4, wherein
the first anode electrode of the first sub-pixel is disposed in the first direction from the pixel circuit of the first sub-pixel,
the second anode electrode of the second sub-pixel is disposed in a direction opposite to the first direction from the pixel circuit of the second sub-pixel,
the first anode electrode of the first sub-pixel is disposed at an edge of a display area on which an image is displayed, and
the pixel circuit of the first sub-pixel is disposed in a non-display area.

6. The display device of claim 5, further comprising a dummy sub-pixel disposed at another edge of the display area and sharing a data line with a sub-pixel among the sub-pixels, wherein
the dummy sub-pixel comprises a pixel circuit and does not comprise a light-emitting element, and
the pixel circuit of the dummy sub-pixel is disposed in the display area.

7. The display device of claim 3, wherein
the sub-pixels of the row further comprise a fourth sub-pixel emitting light of the second color, and
an anode electrode of the fourth sub-pixel comprises:
an emission region;
a first protrusion extending from the emission region and electrically connected to a component via a contact hole, the component is disposed under the contact hole; and
a second protrusion having a shape symmetrical to the first protrusion in the first direction, and
the second protrusion is not physically connected to another configuration.

8. The display device of claim 3, wherein
the sub-pixels of the row further comprise a fifth sub-pixel and a sixth sub-pixel each emitting light of a third color,
a fifth anode electrode of the fifth sub-pixel and a sixth anode electrode of the sixth sub-pixel are spaced apart from each other by the same distance from the third anode electrode of the third sub-pixel,
the fifth anode electrode of the fifth sub-pixel and the sixth anode electrode of the sixth sub-pixel have different planar shapes, and
each of the fifth anode electrode and the sixth anode electrode is smaller than the third anode electrode in plan view.

9. The display device of claim 8, wherein
the sixth anode electrode is disposed on a side of the third anode electrode and comprises a portion extending from a corresponding emission region and connected to a pixel circuit of the sixth sub-pixel via a contact hole disposed on another side of the third anode electrode, and
the portion of the sixth anode electrode extends while bypassing the third anode electrode.

10. The display device of claim 8, wherein
the sixth sub-pixel further comprises a connection line connecting the sixth anode electrode disposed at a side of the third anode electrode to a pixel circuit disposed of the sixth sub-pixel on another side of the third anode electrode, and
the connection line overlaps the third anode electrode.

11. The display device of claim 3, wherein the first color is red, and the second color is blue..

12. The display device of claim 11, wherein
the pixel circuit of the first sub-pixel is disposed in a first direction from the first anode electrode of the first sub-pixel,
the pixel circuit of the second sub-pixel is positioned in an opposite direction from the first direction,
the display device further comprises a dummy sub-pixel sharing a data line with a sub-pixel disposed at an edge of a display area among the sub-pixels,
the dummy sub-pixel comprises the pixel circuit and does not comprise the light-emitting element,
the pixel circuit of the sub-pixel is disposed in the display area, and
the pixel circuit of the dummy sub-pixel is disposed in a non-display area.

13. An electronic device, comprising:
a processor providing input image data;
a display device displaying an image based on the input image data; and
a power supply supplying power to the display device, wherein
the display device comprises a row comprising sub-pixels, the sub-pixels of the row comprise:
a first sub-pixel and a second sub-pixel each emitting light of a first color; and
a third sub-pixel emitting light of a second color,
a third anode electrode of the third sub-pixel is disposed between a first anode electrode of the first sub-pixel and a second anode electrode of the second sub-pixel,
the first anode electrode of the first sub-pixel and the second anode electrode of the second sub-pixel are separated by the same distance from the third anode electrode of the third sub-pixel, and
the first anode electrode of the first sub-pixel and the second anode electrode of the second sub-pixel may have planar shapes substantially symmetrical to each other with respect to the third anode electrode of the third sub-pixel.

14. The electronic device of claim 13, wherein
each of the sub-pixels comprises a light-emitting element and a pixel circuit supplying a driving current to the light-emitting element,
in the row, pixel circuits of two first sub-pixels emitting light of the first color among the sub-pixels are adjacent to each other in a first direction and are connected in common to a first data line, and
in the row, pixel circuits of two third sub-pixels emitting light of the second color among the sub-pixels are adjacent to each other in the first direction and are connected in common to a second data line.

15. The electronic device of claim 14, further comprising a window arranged on the display device, wherein
the window comprises a light blocking area including an opaque material or a colored material, and
the pixel circuit of the first sub-pixel overlaps the light blocking area of the window.
